# EUROPEAN PATENT APPLICATION

(11) **EP 4 607 588 A1**
(43) Date of publication of application: **27.08.2025**
(21) Application number: 24206079.6
(22) Date of filing: 11.10.2024
(51) Int. Cl.: H01L 23/48, H01L 23/528, H01L 23/367, H01L 21/768, H01L 23/535, H01L 23/532, H01L 21/74, H01L 23/485

(54) **SEMICONDUCTOR CIRCUIT STRUCTURE**

(30) Priority: 21.02.2024 US 202463555918 P; 13.05.2024 US 202418662422
(71) Applicant: Invention and Collaboration Laboratory, Inc., Taipei City 114754 (TW)
(72) Inventor: LU, Chao-Chun, 30078 Hsinchu (TW)
(74) Representative: Krauns, Christian

(57) **Abstract**

Semiconductor circuit structures are provided. The semiconductor circuit structure includes a semiconductor substrate with an original semiconductor surface, a set of transistors formed based on the semiconductor substrate, a first STI region neighboring the set of transistors and extending along a first direction, a big STI region remote from the set of transistors, a first underground interconnection line within the first STI region and positioned under the original semiconductor surface, and a first underground interconnection pad electrically coupled to the first underground interconnection line. Each transistor includes a gate structure, a first conductive region, and a second conductive region. The first underground interconnection line extends along the first direction. The first underground interconnection pad is positioned within the big STI region and under the original semiconductor surface. A width of the first underground interconnection pad is greater than a width of the first underground interconnection line.

## Description

### BACKGROUND

### Technical Field

The present disclosure relates to semiconductor structures, and more particularly to semiconductor circuit structures.

### Description of the Related Art

In the state-of-the-art integrated circuits, there are many transistors connected by conductive interconnections, such as metal wires and polysilicon wires, to facilitate the signal transfer among the gate, the source and the drain regions (GSD) of these transistors. These conductive interconnection connect the gate, source and drain regions of the transistors through numerous contact holes and connecting plugs, resulting in significant challenges and difficulties in chip design goals of reducing area, reducing power consumption, reducing noise, and improving integrated circuit performance. To give an example about concerning on the area penalty: the size of the source or drain diffusion area must be designed to be larger than the size of the contact hole used to connect the conductive interconnections to source region or drain region in order to avoid unavoidable photolithographic misalignment, which results from the limitations of lithography equipment, causing the contact holes to be formed outside the underneath edges of the source region or drain region. This inevitably increases diffusion areas of transistors and thus die areas, which induces large capacitances to cause significant penalties to the AC performance of circuits, to consume higher power and to add larger noises.

Therefore, how to introduce better self-aligned contact structures and technologies to connect transistors to the first interconnection (Metal) layer with a smaller surface area for transmitting and receiving signals is a key challenge to effectively scale down integrated circuits and improve performance of integrated circuits.

Moreover, the monolithic integration capability of a Silicon chip has developed from GSI (Giga Scale Integration: Over billions of transistors on a die) to TSI (Tera Scale Integration: Trillions of transistors on a die), and running such a large number of transistors cause a sharp increase in power consumption. The increased power consumption elevates adversely the junction temperature of transistors and thus the entire chip temperature due to current limited heat-dissipation capability. Thermal conductivity index of Silicon-dioxide is very low and that of Silicon itself is not very high. This material and device structural problem causes a negative cyclic effect, that is, the elevated higher die temperature slows down the speed of transistors, and then inevitably enforcing the design to increase higher power to circuitry in order to accelerate the transistor performance but this mechanism causes badly raising the die temperature, and consequently the heat-dissipation problem is getting worse. This insufficient heat dissipation problem causing higher temperature to chip operation is regarded as the worst problem for the entire chip industry to solve to avoid a major roadblock to a larger number of device integration on a die. The progress of reducing the temperature of a GSI chip is not improved well as it should be, however. Actually as the transistor dimensions must be made smaller as the technology node is being scaled further (e.g. the minimum feature size is being scaled from 7nm to 5nm, then to 3nm and so forth), the percentage of oxide coverage to the total transistor size is getting higher and the thermal dissipation capability across the device junctions is further being aggregated. Though a lot of heat dissipation methods are created, for example, covering the entire chip with higher heat-removal pad outside the chip or using a liquid cooling circulation outside the packaged chip, etc., all of which are very expensive but returned with low efficiency for effectively reducing the junction temperatures of transistors.

### SUMMARY

An embodiment of the present disclosure provides a semiconductor circuit structure. The semiconductor circuit structure includes a semiconductor substrate with an original semiconductor surface, a set of transistors formed based on the semiconductor substrate, a first shallow trench isolation (STI) region neighboring the set of transistors and extending along a first direction, a big shallow trench isolation (STI) region remote from the set of transistors, a first underground interconnection line within the first STI region and positioned under the original semiconductor surface, and a first underground interconnection pad electrically coupled to the first underground interconnection line. Each transistor includes a gate structure, a first conductive region, and a second conductive region. The first underground interconnection line extends along the first direction. The first underground interconnection pad is positioned within the big STI region and under the original semiconductor surface. A width of the first underground interconnection pad is greater than a width of the first underground interconnection line.

According to an aspect of the present disclosure, the first underground interconnection pad is directly connected to the first underground interconnection line.

According to an aspect of the present disclosure, the semiconductor circuit structure further includes a through semiconductor via (TSV) extending from a bottom surface of the first underground interconnection pad to a backside surface of the semiconductor substrate, wherein the TSV is electrically connected to the first underground interconnection pad and configured to transmit a power signal or a data signal from the backside surface of the semiconductor substrate to the first underground interconnection pad, and the backside surface is opposite to the original semiconductor surface.

According to an aspect of the present disclosure, the first conductive region of a first transistor of the set of transistors is electrically connected to the first underground interconnection line through a connecting plug positioned within an active area accommodating the first transistor, and the power signal or the data signal is transmitted to the first transistor through the first underground interconnection pad, the first underground interconnection line, and the corresponding connecting plug.

According to an aspect of the present disclosure, the connecting plug contacts a sidewall of the first underground interconnection line.

According to an aspect of the present disclosure, both the first underground interconnection pad and the first underground interconnection line include W and TiN.

According to an aspect of the present disclosure, the TSV includes a Cu pillar.

According to an aspect of the present disclosure, the semiconductor circuit structure further includes a conducting pad close to the backside surface of the semiconductor substrate and connected to the TSV.

According to an aspect of the present disclosure, the semiconductor circuit structure further includes a second shallow trench isolation (STI) region remote from the set of transistors, and a second underground interconnection line within the second STI region and positioned under the original semiconductor surface, wherein the second underground interconnection line extends along a second direction different from the first direction, and the second underground interconnection line is connected to the first underground interconnection line.

According to an aspect of the present disclosure, the semiconductor circuit structure further includes a second shallow trench isolation (STI) region remote from the set of transistors, and a second underground interconnection line within the second STI region and positioned under the original semiconductor surface, wherein the second underground interconnection line extends along a second direction different from the first direction, and the second underground interconnection line is connected to the first underground interconnection pad.

According to an aspect of the present disclosure, the semiconductor circuit structure further includes a plurality of metal layers positioned above the original semiconductor surface and vertically separately from each other, and a plurality of connecting vias above the original semiconductor surface and electrically connected to the plurality of metal layers, wherein the first conductive region of a first transistor of the set of transistors is electrically connected to the first underground interconnection pad through the plurality of metal layers and the plurality of connecting vias.

According to an aspect of the present disclosure, the semiconductor circuit structure further includes a plurality of metal layers positioned above the original semiconductor surface and vertically separately from each other, a plurality of connecting vias above the original semiconductor surface and electrically connected to the plurality of metal layers, and a second underground interconnection pad positioned under the original semiconductor surface, wherein a width of the second underground interconnection pad is greater than the width of the first underground interconnection line, and the first underground interconnection pad is electrically connected to the second underground interconnection pad through the plurality of metal layers and the plurality of connecting vias.

Another embodiment of the present disclosure provides a semiconductor circuit structure. The semiconductor circuit structure includes a semiconductor substrate with an original semiconductor surface, a set of transistors formed based on the semiconductor substrate, a first shallow trench isolation (STI) region neighboring the set of transistors and extending along a first direction, a second shallow trench isolation (STI) region remote from the set of transistors, a big shallow trench isolation (STI) region remote from the set of transistors, a first underground interconnection line within the first STI region and positioned under the original semiconductor surface, a second underground interconnection line within the second STI region and positioned under the original semiconductor surface, and a first underground interconnection pad positioned within the big STI region and under the original semiconductor surface. The first underground interconnection line extends along the first direction. The second underground interconnection line extends along a second direction different from the first direction. The second underground interconnection line is connected to the first underground interconnection line or the first underground interconnection pad.

According to an aspect of the present disclosure, a width of the first underground interconnection pad is greater than a width of the first underground interconnection line.

According to an aspect of the present disclosure, the first underground interconnection pad is connected to the first underground interconnection line.

According to an aspect of the present disclosure, the semiconductor circuit structure further includes a third shallow trench isolation (STI) region remote from the set of transistors, and a third underground interconnection line within the third STI region and positioned under the original semiconductor surface, wherein the third underground interconnection line extends along the first direction, and the second underground interconnection line is between and connected to the first underground interconnection line and the third underground interconnection line.

Another embodiment of the present disclosure provides a semiconductor circuit structure. The semiconductor circuit structure includes a semiconductor substrate with an original semiconductor surface, a set of transistors formed based on the semiconductor substrate, a first shallow trench isolation (STI) region neighboring the set of transistors and extending along a first direction, a big shallow trench isolation (STI) region remote from the set of transistors, a first underground interconnection line within the first STI region and positioned under the original semiconductor surface, a first underground interconnection pad electrically coupled to the first underground interconnection line, and a through semiconductor via (TSV) within the big STI region and connected to the first underground interconnection pad. Each transistor includes a gate structure, a first conductive region, and a second conductive region. The first underground interconnection line extends along the first direction. The first underground interconnection pad is positioned within the big STI region and under the original semiconductor surface.

According to an aspect of the present disclosure, the big STI region extends from an edge of the first STI region, and the first underground interconnection pad is directly connected to the first underground interconnection line.

According to an aspect of the present disclosure, the TSV extends from a bottom surface of the first underground interconnection pad to a backside surface of the semiconductor substrate, and is configured to transmit a power signal or a data signal from the backside surface of the semiconductor substrate to the first underground interconnection pad, and the backside surface is opposite to the original semiconductor surface.

According to an aspect of the present disclosure, the first conductive region of a first transistor of the set of transistors is electrically connected to the first underground interconnection line through a connecting plug positioned within an active area accommodating the first transistor, and the power signal or the data signal is transmitted to the first transistor through the first underground interconnection pad, the first underground interconnection line, and the corresponding connecting plug.

According to an aspect of the present disclosure, the connecting plug contacts a sidewall of the first underground interconnection line.

According to an aspect of the present disclosure, the semiconductor circuit structure further includes a conducting pad close to the backside surface of the semiconductor substrate and connected to the TSV.

The above and other embodiments of the disclosure will become better understood with regard to the following detailed description of the non-limiting embodiment(s). The following description is made with reference to the accompanying drawings.

### BRIEF DESCRIPTION OF THE DRAWINGS

FIG. 1 illustrates a schematic top view of a conventional semiconductor circuit structure with STI regions and active areas.
FIG. 2A illustrates a schematic top view of a semiconductor circuit structure according to some embodiments of the present disclosure.
FIG. 2B is a schematic cross-sectional view of the semiconductor circuit structure illustrated along the lines BB' shown in FIG. 2A.
FIG. 2C is a schematic cross-sectional view of the semiconductor circuit structure illustrated along the lines CC' shown in FIG. 2A.
FIG. 2D illustrates a schematic top view of a semiconductor circuit structure according to some embodiments of the present disclosure.
FIG. 2E illustrates a schematic top view of a semiconductor circuit structure according to some embodiments of the present disclosure.
FIG. 3 illustrates a schematic top view of a semiconductor circuit structure according to some embodiments of the present disclosure.
FIG. 4 illustrates a schematic cross-sectional view of a semiconductor circuit structure according to some embodiments of the present disclosure.
FIG. 5 illustrates a schematic cross-sectional view of a semiconductor circuit structure according to some embodiments of the present disclosure.
FIG. 6 illustrates a schematic cross-sectional view of a semiconductor circuit structure according to some embodiments of the present disclosure.
FIG. 7 illustrates a schematic cross-sectional view of a semiconductor circuit structure according to some embodiments of the present disclosure.
FIG. 8 illustrates a schematic cross-sectional view of a semiconductor circuit structure according to some embodiments of the present disclosure.
FIG. 9 illustrates a schematic cross-sectional view of a semiconductor circuit structure according to some embodiments of the present disclosure.
FIG. 10 illustrates a schematic cross-sectional view of a semiconductor circuit structure according to some embodiments of the present disclosure.
FIG. 11A shows the temperature distribution of a FinFET established by Sentaurus of TCAD.
FIG. 11B shows a temperature difference versus thickness of STI region.
FIG. 12 illustrates a schematic cross-sectional view of a semiconductor circuit structure according to some embodiments of the present disclosure.
FIGS. 13A to 21 illustrate a method for manufacturing underground interconnection structures within STI regions according to some embodiments of the present disclosure.
FIGS. 22A to 29C illustrate a method for manufacturing underground interconnection structures within STI regions according to some embodiments of the present disclosure.
FIGS. 30A to 30B illustrate a method for manufacturing an UGI mesh according to some embodiments of the present disclosure.

### DETAILED DESCRIPTION

Various embodiments will be described more fully hereinafter with reference to accompanying drawings, which are provided for illustrative and explaining purposes rather than a limiting purpose. For clarity, the components may not be drawn to scale. In addition, some components and/or reference numerals may be omitted from some drawings. It is contemplated that the elements and features of one embodiment can be beneficially incorporated in another embodiment without further recitation. In the following methods for manufacturing semiconductor devices, there may be one or more additional operations between the operations described, and the order of the operations may vary. The illustration uses the same/similar reference numerals to indicate the same/similar elements.

As used in the specification and the appended claims, the ordinals such as "first", "second" and the like to describe elements do not imply or represent a specific position in the structure, or the order of arrangement, or the order of manufacturing. The ordinals are only used to clearly distinguish multiple elements with the same name. As used in the specification and the appended claims, spatial relation terms such as "on", "above", "over", "upper," "top", "below", "beneath", "under", "lower", "bottom" and the like may be used to describe the relative spatial relations or positional relations between one element(s) and another element(s) as illustrated in the drawings, and these spatial relations or positional relations, unless specified otherwise, can be direct or indirect. The spatial relation terms are intended to encompass different orientations of structures in addition to the orientation depicted in the drawings. The structure can be inverted or rotated by various angles, and the spatial relation descriptions used herein can be interpreted accordingly.

Additionally, the terms "electrically connected" and "electrically coupled" used in the specification and claims can refer to an ohmic contact between elements, or current passing through elements, or an operational relation between elements. The operational relation may mean, for example, that one element is used to drive another element, but current may not flow directly between these two elements.

The present disclosure focuses on semiconductor circuit structures including underground interconnection (UGI) structures within semiconductor substrate for signal delivery and/or heat dissipation. The signal delivery includes power signal delivery and data signal delivery. The UGI structure may be made in a monolithic integrated circuit fabrication process. The underground interconnection structure may include an underground interconnection line (UGI line), an underground interconnection pad (UGI pad), etc. The underground interconnection structure within the semiconductor substrate forms a middle side signal delivery network ("Mid-side Signal Network") and/or heat dissipation network, which can improve performance of integrated circuits.

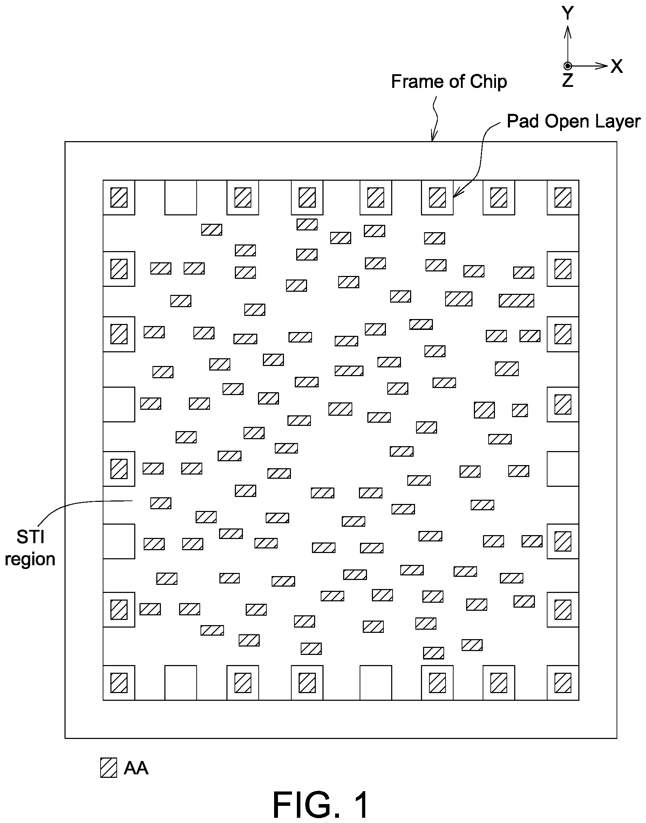

In conventional semiconductor circuit structure of a semiconductor substrate, there are many active regions or active areas (AA) in which the transistors or circuit elements are located, and there are many shallow trench isolation (STI) regions surrounding those active regions, as shown in FIG. 1. However, the STI regions in the semiconductor substrate may occupy 40% or more of total area of the semiconductor substrate, and those STI regions provide no special function except the isolation purpose.

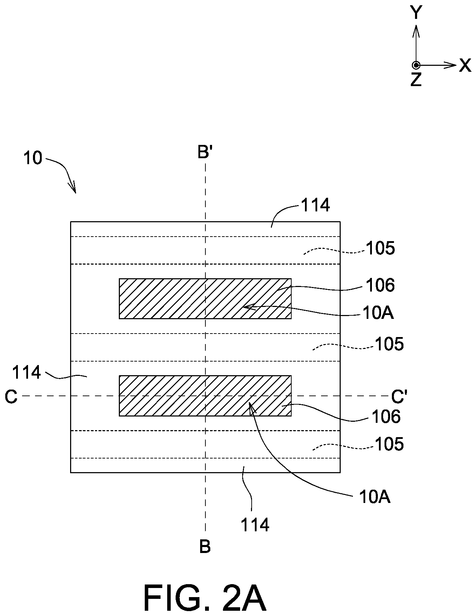

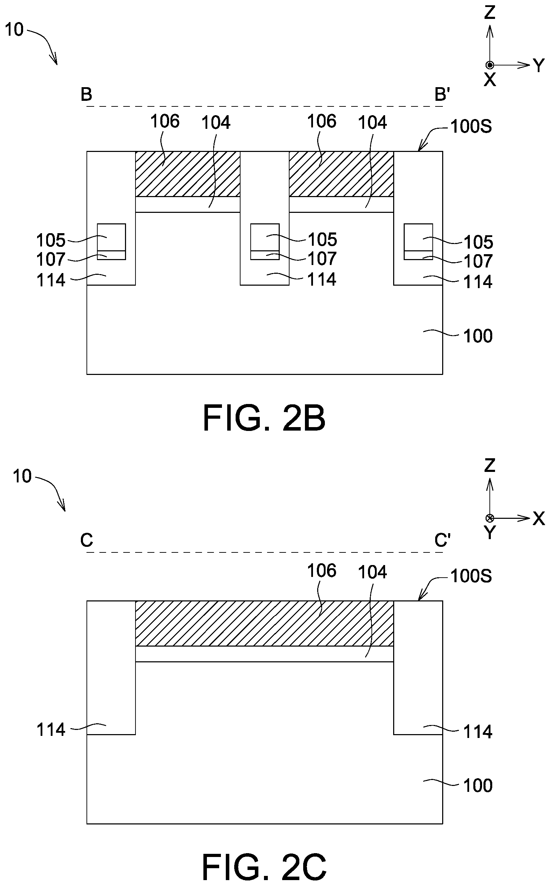

On the other hand, FIG. 2A illustrates a schematic top view of a semiconductor circuit structure 10 according to some embodiments of the present disclosure. FIG. 2B is a schematic cross-sectional view of the semiconductor circuit structure 10 illustrated along the lines BB' shown in FIG. 2A. FIG. 2C is a schematic cross-sectional view of the semiconductor circuit structure 10 illustrated along the lines CC' shown in FIG. 2A. As shown in FIGS. 2A to 2C, the semiconductor circuit structure 10 of the present invention includes a semiconductor substrate 100 with an original semiconductor surface 100S. The semiconductor substrate 100 includes one or more active regions or active areas (AA) 10A, and one or more shallow trench isolation (STI) regions 114. The STI regions 114 surround the active regions 10A and those active areas 10A can be separated from each other by the STI regions 114. The active area 10A can be used to accommodate one or more transistors. Before forming the transistors, a pad-oxide layer 104 and a pad-nitride layer 106 are formed define or protect the active area 10A.

According to the present invention, there are one or more underground interconnection (UGI) structures in the STI regions 114 to replace portion of the original isolation material (such as oxide) in the STI region 114. Those underground interconnection (UGI) structures could provide a predetermined function different from the isolation purpose of the original STI regions 114. Such UGI structures just like "mid-side connectors" in the substrate, and the aforesaid composite STI region including the original isolation material and the UGI structure could be deemed as Heterogeneous STI (HSTI).

In one embodiment, the UGI structure includes an UGI element 105 (such as conductive material or other suitable material) and a barrier layer 107. The barrier layer 107 covers a bottom surface and/or a sidewall of the UGI element 105. The barrier layer 107 shown in FIGS. 2A to 2C can be omitted in some embodiments, that is, the UGI structure may not include the barrier layer 107. The UGI structure is positioned under the original semiconductor surface 100S of the semiconductor substrate 100. Moreover, the UGI structure is formed within the STI region 114. For example, as shown in FIG. 2B, the UGI element 105 is sandwiched by the material of the STI regions 114. In the present embodiment, the UGI structure extends along the X direction, and the STI region 114 extends along the X direction as well. In such case, the UGI structure or UGI element could be a UGI line.

In one example, the UGI structure or UGI element within and extending along the STI region 114 can be connected to, through a self-aligned or self-constructed method, a source terminal or a drain terminal of the transistor by a connecting plug within the active area 10A. The connecting plug is connected to a sidewall of the UGI structure.

The UGI structure within the STI region 114 can be used for signal delivery (including power signal and data signal) and/or heat dissipation. For signal delivery, the UGI element 105 may include (or may be made of) metal such as tungsten, and the barrier layer 107 may include (or may be made of) titanium nitride (TiN). There still exists some appropriate metal layers suitably used for UGI element 105 rather than be limited a specific type of metal material. For heat dissipation, the UGI element 105 may include material with thermal conductivity higher than the original isolation material (such as oxide) in the STI region 114, such as AIN, BN, SiC, and metal, etc.

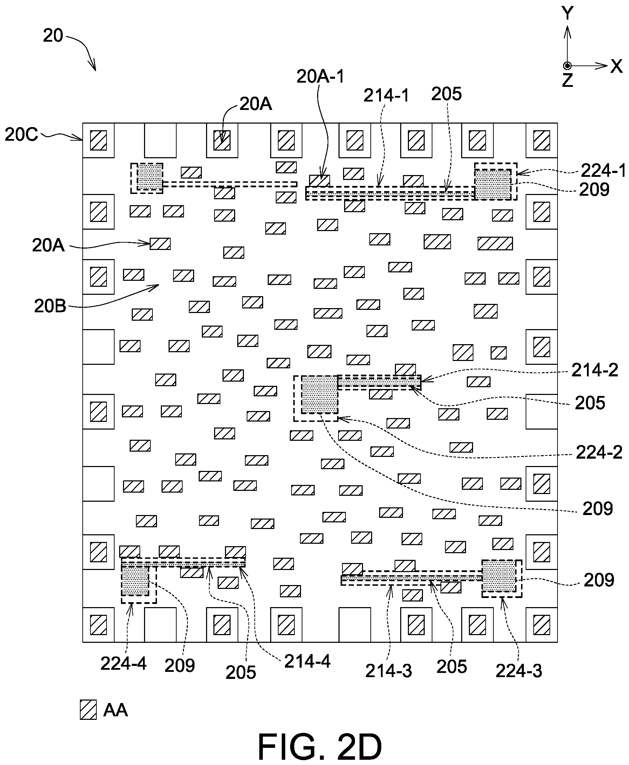

FIG. 2D illustrates a schematic top view of a semiconductor circuit structure 20 according to one embodiment of the present disclosure. The semiconductor circuit structure 20 can be formed within a semiconductor chip or substrate. FIG. 2D shows more active areas or active regions 20A, STI regions 20B, and pad open layers 20C which may accommodate contacting pads of the semiconductor circuit structure 20. Some big STI regions 224-1~224-4 of the STI regions 20B could be located at corner area adjacent to peripheral/edge area of the semiconductor chip, or at center spare area of the chip. Big UGI structures (such as UGI pads) 209 are located within the big STI regions 224-1~224-4 and positioned under the original semiconductor surface of the semiconductor substrate. Additionally, other thin or long UGI structures (such as UGI line) 205 are positioned under the original semiconductor surface of the semiconductor substrate and formed within those thin or long STI regions 214-1~214-4 of the STI region 20B. The UGI structures 205 and the STI regions 214-1~214-4 may extend along the X direction (or along the length direction of active areas). Furthermore, the UGI structure 205 may extend over two or more active regions 20A, e.g., the UGI structure 205 located in the top-right portion of FIG. 2D extends from one predetermined point of STI region 214-1 adjacent to the active area 20A-1 to the big STI region 224-1.

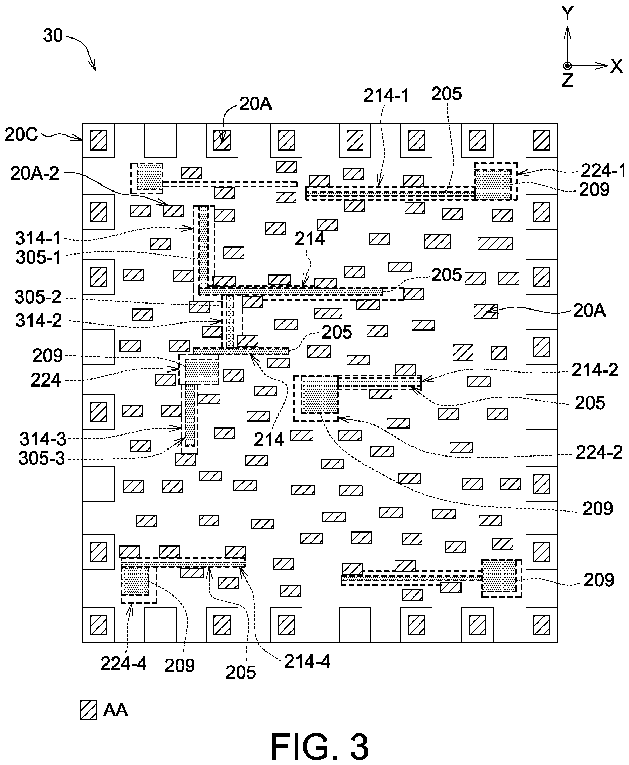

In FIG. 3, on one side of the STI regions 214-1, there is a first set of active regions extending along the x direction; and one the other side of the STI regions 214-1, there is a second set of active regions extending along the x direction as well. Thus, the STI regions 214-1 is between the first set of active regions and the second set of active regions, and extends along the x direction. Moreover, the VHDC structure 205 within the STI regions 214-1 is also between the first set of active regions and the second set of active regions and extends along the x direction. In one embodiment, the smallest one and/or the longest width of the VHDC structure 205 (such as, along the y direction) between the first set of active regions and the second set of active regions is smaller than the width of the VHDC structure 209 (such as, along the y direction) connected to the VHDC structure 205.

Each of the STI regions 214-1~214-4 may neighbor a set of transistors in the active areas 20A, and the big STI region 224-1 may be remote from the set of transistors. The UGI structure 205 is electrically coupled to or directly connected to the UGI structure 209. Each of the UGI structures 205 and 209 may include an UGI element and a barrier layer, as shown in FIG. 2A~FIG. 2C. In some embodiment, the UGI structures 205 and 209 may not include barrier layers.

The width of the big STI regions 224-1 along the Y direction is greater the width of the STI regions 214-1 along the Y direction. The width of the UGI structure 209 along the Y direction is greater the width of the UGI structure 205 along the Y direction. For example, the width of the UGI structure 209 along the Y direction may range from about 2 µm (micrometer) to about 8 µm. The width of the UGI structure 205 along the Y direction may range from about 10 nm (nanometer) to about 100 nm. The area of the UGI structure 209 may range from about 4 µm² to about 50 µm². For signal delivery, the UGI structures 205 and 209 may include (or may be made of) metal such as tungsten. The materials of the UGI structures 205 and 209 may be the same or different.

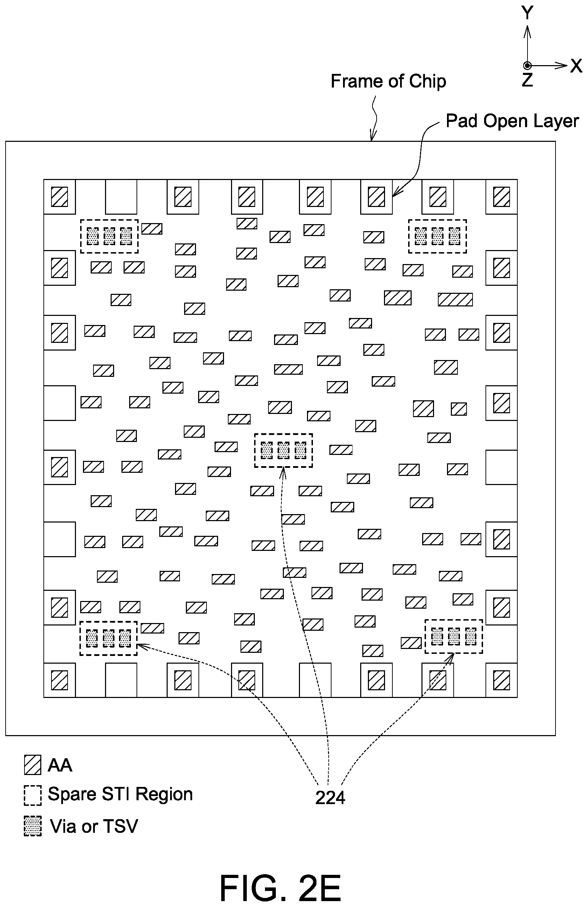

The big STI regions 224 may form extra alignment marks for the backside signal/power deliver network and backside TSV (through silicon via), that is, the signal/power is delivered to the active regions from the backside of the active regions, as shown in FIG. 2E. Of course, those big STI regions 224 may form extra alignment marks for the topside signal/power deliver network and topside TSV, that is, the signal/power is delivered to the active regions from the topside of the active regions.

In other embodiments, the UGI structures may extend along directions other than the X direction, as shown in FIG. 3. FIG. 3 illustrates a schematic top view of a semiconductor circuit structure 30 according to some embodiments of the present disclosure. As compared with the semiconductor circuit structure 20 shown in FIG. 2D, the semiconductor circuit structure 30 shown in FIG. 3 further includes STI regions 314-1, 314-2 and 314-3, and UGI structures 305-1, 305-2 and 305-3 extending along the Y direction. The UGI structures 305-1, 305-2 and 305-3 are positioned under the original semiconductor surface of the semiconductor substrate and formed within the STI regions 314-1, 314-2 and 314-3 respectively. The UGI structures 305-1, 305-2 and 305-3 can be UGI lines. The UGI structures 305-1, 305-2 and 305-3 and the STI regions 314-1, 314-2 and 314-3 may extend along the Y direction (or along the width direction of active areas). Furthermore, the UGI structure 305-1, 305-2 and 305-3 may extend over two or more active regions 20A, e.g., the UGI structure 305-1 located in the top-left portion of FIG. 3 extends from one predetermined point of STI region 314-1 adjacent to the active area 20A-2 to the horizontal STI region 214. Each of the STI regions 314-1, 314-2 and 314-3 may neighbor a set of transistors in the active areas 20A.

In FIG. 3, the UGI structures extending along directions other than the X direction may be connected to (or electrically coupled to) the UGI structures extending along the X direction and/or the UGI pads within the big STI regions. For example, the UGI structure 305-1 is connected to (or electrically coupled to) the UGI structure 205; the UGI structure 305-2 is connected to (or electrically coupled to) two UGI structures 205 and between these two UGI structures 205; the UGI structure 305-3 is connected to (or electrically coupled to) the UGI pad 209 within the big STI region 224. The UGI structures 305-1, 305-2 and 305-3 can be similar in size and material to the UGI structures 205. Each of the UGI structures 305-1, 305-2 and 305-3 may include an UGI element (or further with a barrier layer), as shown in FIG. 1.

With the arrangement of the UGI structures/lines extending along the X direction, the UGI structures/lines extending along the Y direction (or directions other than the X direction), and the UGI pads within the big STI regions, an UGI mesh (or Mid-Side Signal Network) within the chip or the semiconductor substrate and under the original semiconductor surface of the semiconductor substrate is provided. The UGI structures extending along the X direction (i.e. the horizontal UGI lines) can be used to connect the UGI structures within the big STI regions (i.e. the UGI pads) or the source/drain of transistors within the active areas, and the UGI structures extending along the Y direction (i.e. the vertical UGI lines) can be used to connect the UGI pads or the horizontal UGI lines.

### 1. Mid-Side Signal Power Network based on UGI

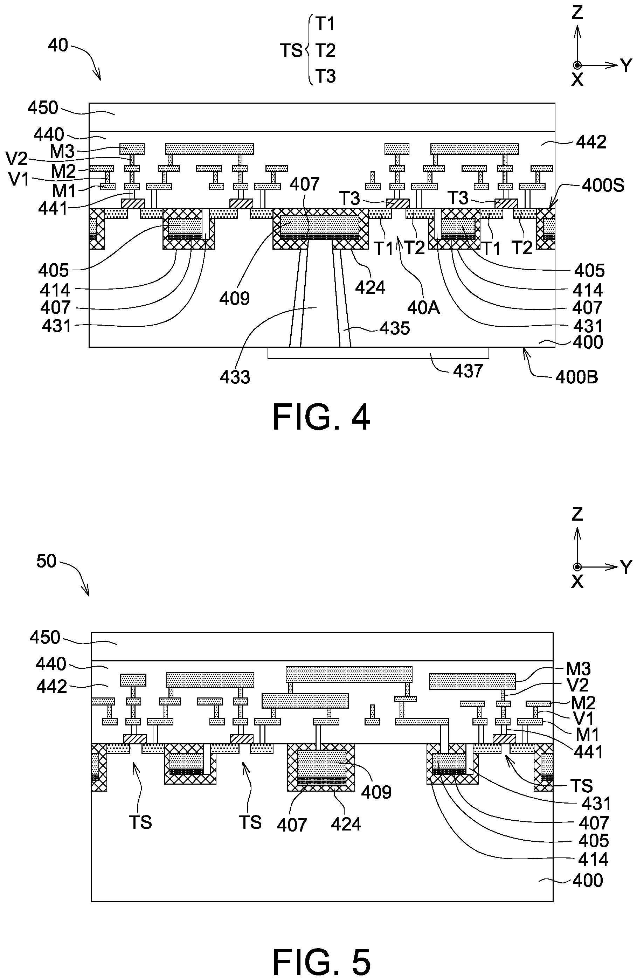

FIGS. 4 to 6 relate to Mid-side signal/power networks based on the UGI structures. For the arrangement of UGI structures on the X-Y plane, please refer to the descriptions related to FIGS. 2 and 3. The position, size, number of the UGI structures are not limited to the those shown in FIGS. 2 and 3.

In some embodiments, the big STI regions, as shown in FIGS. 2 and 3, can be adopted to align with one or more TSVs, as shown in FIG. 4. FIG. 4 illustrates a schematic cross-sectional view of a semiconductor circuit structure 40 according to some embodiments of the present disclosure. The semiconductor circuit structure 40 includes a semiconductor substrate 400 with an original semiconductor surface 400S, active areas 40A in the semiconductor substrate 400, transistors TS formed based on the semiconductor substrate 400 and in the active areas 40A, STI regions 414, a big STI region 424, first UGI structures within the STI regions 414, and a second UGI structure within the big STI region 424. Each transistor TS includes a first conductive region (such as source) T1, a second conductive region (such as drain) T2 and a gate structure T3. The first UGI structure (such as UGI line) within the STI region 414 and the second UGI structure (such as UGI pad) within the big STI region 424 are positioned under the original semiconductor surface 400S of the semiconductor substrate 400, and the first UGI structure extends along the X direction. Each of the first UGI structure may include an UGI element 405 and a barrier layer 407 on the bottom surfaces and/or sidewalls of the UGI element 405. Each of the second UGI structure may include an UGI element 409 and a barrier layer 407 on the bottom surfaces and/or sidewalls of the UGI element 409. The semiconductor circuit structure 40 further includes connecting plugs 431 contacting sidewalls of the UGI elements 405 of the first UGI structures and electrically coupled to the transistor TS and the first UGI structure. The power signal or the data signal can be transmitted to the transistor TS through the second UGI structure, the first UGI structure, and the corresponding connecting plug 431. The connecting plug 431 is positioned within an active area accommodating the transistor TS.

The semiconductor circuit structure 40 further includes a TSV 433 right under and connected to the second UGI structure (i.e. the UGI pad) within the big STI region 424, and a barrier or isolating film 435 on a sidewall of the TSV 433. The TSV 433 extends from the bottom surface of the second UGI structure to the backside surface 400B of the semiconductor substrate 400. The backside surface 400B is opposite to the original semiconductor surface 400S. The TSV 433 can be understood as a backside TSV. The TSV 433 can be electrically connected to the second UGI structure. A power signal or a data signal can be transmitted from the backside surface 400B of the semiconductor substrate 400 to the second UGI structure. The TSV 433 can be connected to the backside conducting pad 437 located on or close to the backside surface 400B of the semiconductor substrate 400 (or on the backside of the chip). The backside conducting pad 437 can be a power signal or data signal input. Thus, the present disclosure provides convenient and efficient method to realize backside signal delivery network. The TSV 433 may include a conductive material such as copper. The TSV 433 may be or may include a Cu pillar. The barrier film 435 may include a dielectric material such as oxide.

The semiconductor circuit structure 40 further includes an upper interconnection structure 440 on the semiconductor substrate 400 and a bonding layer 450 on the upper interconnection structure 440. The upper interconnection structure 440 includes a contact structure 441, metal layers M1 to M3, connecting vias V1 and V2, and a dielectric layer 442. The contact structure 441, the metal layers M1 to M3, and the connecting vias V1 and V2 are in the dielectric layer 442 which may include multiple dielectric sub-layers. The contact structure 441 is between the transistor TS and the metal layer M1. The metal layers M1 to M3 are sequentially positioned above the original semiconductor surface 400S of the semiconductor substrate 400 along the Z direction. The metal layers M1 to M3 are vertically separately from each other. The connecting vias V1 and V2 are positioned above the original semiconductor surface 400S of the semiconductor substrate 400. The connecting via V1 is between the metal layers M1 and M2. The connecting via V2 is between the metal layers M2 and M3. The metal layers M1 to M3 and the connecting vias V1 and V2 are electrically connected to each other. The transistors TS are electrically coupled to the metal layer M1 through the contact structure 441. The power signal or the data signal can be transmitted between the backside conducting pad 437, the TSV 433, the second UGI structure, the first UGI structure, the transistor TS, the contact structure 441, the metal layers M1 to M3, and the connecting vias V1 and V2.

The conventional semiconductor circuit structure without the proposed UGI structures may suffers misalignment problem for the TSV, and additionally the TSV needs to go deeper depth to connect to transistors through the metal layers in the upper interconnection structure 440. On the other hand, as shown in FIG. 4, with the use of the UGI structures (including the UGI line and/or UGI pad), the present disclosure provides bigger misalignment tolerance for the TSV due to the bigger STI region accommodating UGI pads, and causes the backside TSV to go shorter path to connect the transistors through UGI structures without through the metal layers in the upper interconnection structure 440. Therefore, the IR drop between the TSV and the transistors can be significantly improved.

FIG. 5 illustrates a schematic cross-sectional view of a semiconductor circuit structure 50 according to another embodiment of the present invention. The differences between the semiconductor circuit structure 50 shown in FIG. 5 and the semiconductor circuit structure 40 shown in FIG. 4 is that, the semiconductor circuit structure 50 does not include a backside TSV. Without using the backside signal delivery by backside TSV, the power/data signal could be transmitted to the second UGI structure or the first UGI structure from the top side of the chip through the metal layers M1 to M3 and/or the connecting vias V1 and V2 in regular foundry process. Additionally, if necessary, the second UGI structure and the first UGI structure can also be connected to the transistor (or other UGI structures) through the metal layers M1 to M3 and the connecting vias V1 and V2. The first conductive region or the second conductive region of the transistor TS can be electrically connected to the second UGI structure through the metal layers M1 to M3 and the connecting vias V1 and V2.

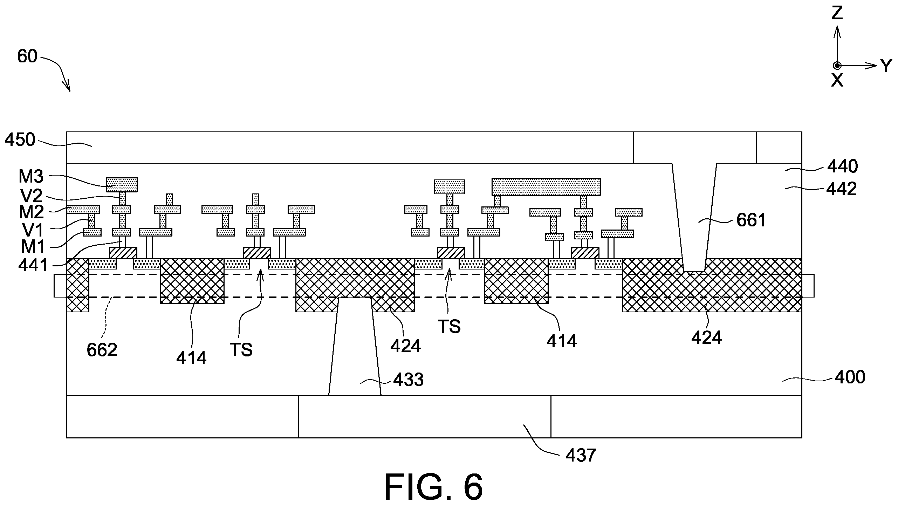

FIG. 6 illustrates a schematic cross-sectional view of a semiconductor circuit structure 60 according to some embodiments of the present disclosure. As shown in FIG. 6, one second UGI structure (i.e. the UGI pad not shown in FIG. 6) within one big STI region 424 is connected to a backside TSV 433 for backside signal delivery, and another second UGI structure (i.e. the UGI pad not shown in FIG. 6) within another big STI region 424 is connected to one connecting via 661 (topside down via) over the top of the chip/semiconductor substrate 400 for topside signal delivery. Some first UGI structures (i.e. the UGI lines not shown in FIG. 6) could extend along the X direction and within the STI regions 414. Moreover, the semiconductor circuit structure 60 may include one or more first UGI structures 662 (i.e. the UGI line marked by dash line in FIG. 6) extending along Y direction. The UGI line 662 may connect the UGI lines in STI regions 414 and/or the UGI pads in big STI regions 424. Thus, the UGI pads and the UGI lines extending along different directions can be connected to each other to form the UGI mesh, and the source terminal of the transistors TS can be connected to some UGI lines.

### 2. Heat Dissipation Network based on UGI

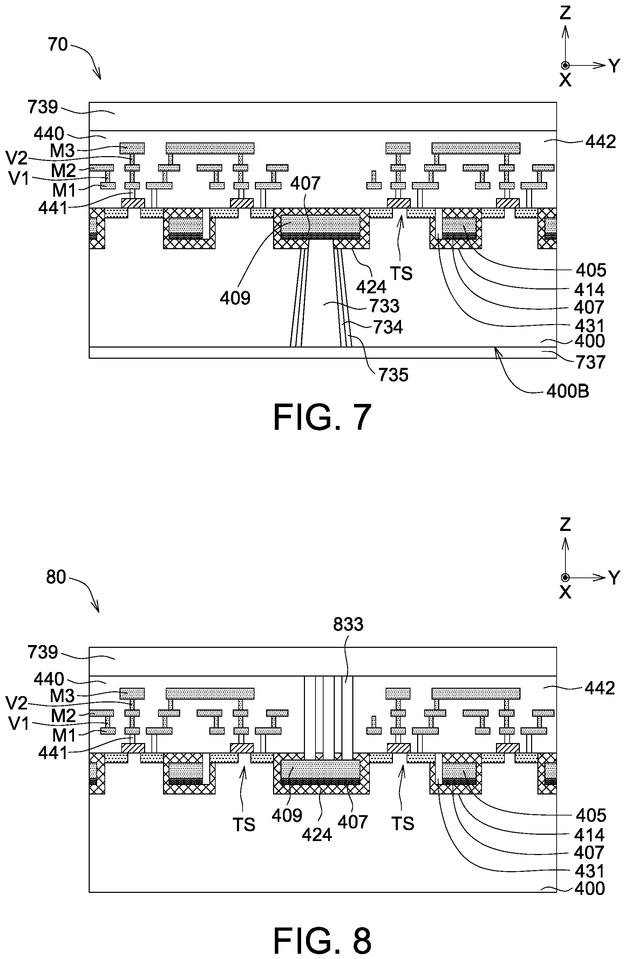

FIGS. 7 to 10 relate to heat dissipation networks within middle side of the chip or semiconductor substrate based on the UGI structures according to the present disclosure. For the arrangement of UGI structures on the X-Y plane, please refer to the descriptions related to FIGS. 2 and 3. The position, size, number of the UGI structures are not limited to those shown in FIGS. 2 and 3. For heat dissipation application, the UGI structures can include (or can be made of) high thermal conductivity materials such as tungsten (having a thermal conductivity around 170 W/m·K), boron nitride (BN, having a thermal conductivity around 600 W/m·K), aluminum nitride (AlN, having a thermal conductivity around 321 W/m·K). It is also possible that other material with thermal conductivity higher than the original material (such as silicon dioxide) of STI region could be used, such as SiC, SiGe, undoped Si. In some embodiments, the UGI structures can include (or can be made of) composite materials including two or more high thermal conductivity material. Portion of silicon dioxide in the original STI regions can be replaced by the UGI structures, thereby improving the ability of heat dissipation due to the thermal conductivity of the materials of the UGI structures are higher than silicon dioxide and/or silicon.

Similar to the UGI structures used for signal/power delivery, the UGI structures used for heat dissipation extend from some STI regions next to active areas in which transistors are located to the big STI regions in which the UGI pads (for example, the area of the UGI pad may range from about 4 µm² to about 50 µm²) are located, almost the same as those shown in FIGS. 2 and 3. The UGI structures can be thermally coupled to each other. For example, the UGI structure in the big STI region (i.e. the UGI pad) can be thermally coupled to the UGI structure in the STI region (i.e. the UGI line). Furthermore, the big STI regions can be adopted to align with one or more TSVs as shown in FIG. 4, the TSVs can be used for heat dissipation, and the TSVs can be understood as thermal vias. Moreover, compared with the signal/power delivery, all or most of STI regions (such as more than 60%, or even 70%~90%) in the semiconductor chip could be filled with the proposed UGI structures for heat dissipation purpose.

FIG. 7 illustrates a schematic cross-sectional view of a semiconductor circuit structure 70 according to some embodiments of the present disclosure. The major differences between the semiconductor circuit structure 40 shown in FIG. 4 and the semiconductor circuit structure 70 shown in FIG. 7 are that, the semiconductor circuit structure 70 includes a TSV 733 right under and connected to the second UGI structure within the big STI region 424 (i.e. the UGI pad), a heat dissipation film 734 on a sidewall of the TSV 733, a barrier film 735 on a sidewall of the heat dissipation film 734, a heat dissipation plate 737 located on or close to the backside surface 400B of the semiconductor substrate 400 (or on the backside of the chip), and a top heat dissipation plate 739 above the upper interconnection structure 440. The TSV 733 is used for heat dissipation and can be understood as a (backside) thermal via. The heat dissipation plate 737 can be a heat sink and the material of which could be the same as that of the heat dissipation film 734 or the TSV 733. The TSV 733 extends from the bottom surface of the second UGI structure to the backside surface 400B of the semiconductor substrate 400. The TSV 733 is connected between the second UGI structure and the heat dissipation plate 737 to form a heat dissipation path which includes the second UGI structure close to the transistor, the TSV 733 and the heat dissipation plate 737. In some embodiments, the barrier film 735 and/or the heat dissipation film 734 can be omitted.

For heat dissipation, the UGI structures in the present embodiment may include (or may be made of) materials having thermal conductivities higher than the thermal conductivity of SiO₂ and/or Si. For example, the UGI structures may include tungsten, copper, BN, AIN, SiC, SiGe, or undoped Si, or the combination thereof. In some embodiments, the UGI structures include isolation material with a thermal conductivity higher than the thermal conductivity of SiO₂ and/or Si. The TSV 733 may include copper, and the heat dissipation film 734 could be BN or AIN.

Furthermore, the TSV 733 are directly connected to the second UGI structures (such as the UGI pads in the STI isolation 424), the second UGI structures are then connected to the first UGI structures (such as UGI lines in the STI isolation 414), and the first UGI structures are connected to the transistors (such as source/drain regions of the transistors) through the corresponding connecting plug 431. As such, heat generated from the transistor can be dissipated through the connecting plug 431, the first UGI structure, and the second UGI structure to the TSV 733. Thus, an UGI heat dissipation network with high heat dissipation efficiency is provided. In another embodiment, the UGI structures may be isolated from the transistors, but the heat dissipation purpose could be reached through the UGI lines, the UGI pads, and the TSV 733.

The conventional semiconductor circuit structure may only include upper thermal vias in the upper interconnection structure 440 and does not include UGI structures, especially the UGI pads. Therefore, the alignment of the upper thermal vias is a critical issue. In addition, the upper thermal vias of the conventional semiconductor circuit structure are just positioned within and isolated by the dielectric layer 442 of the upper interconnection structure 440, and those upper thermal vias are remoted from the transistors. Thus, the heat generated from the transistors is difficult to be dissipated efficiently. However, the semiconductor circuit structure according to the present disclosure provides bigger misalignment window for the thermal vias through the help of UGI pads. Moreover, the thermal coupling path between the thermal vias and the source/drain terminal of the transistors are shorter through the help of UGI structures. Therefore, heat generated from the transistors can be dissipated efficiently through the configuration of the present disclosure.

FIG. 8 illustrates a schematic cross-sectional view of a semiconductor circuit structure 80 according to some embodiments of the present disclosure. The semiconductor circuit structure 80 includes upper thermal vias 833 in the dielectric layer 442 of the upper interconnection structure 440. The upper thermal vias 833 extend upward from the upper surface of the second UGI structure to the top heat dissipation plate 739 and penetrate the dielectric layer 442 of the upper interconnection structure 440.

Thus, the upper thermal vias 833 are connected the second UGI structure (such as the UGI pads in the STI isolation 424) and the top heat dissipation plate 739, the second UGI structures are then connected to the first UGI structures (such as UGI lines in the STI isolation 414), and the first UGI structures are connected to the transistors (such as source/drain regions of the transistors) through the corresponding connecting plug 431. Therefore, the top heat dissipation plate 739, the upper thermal vias 833, the first and the second UGI structures could form a heat dissipation path for the heat generated by the transistors. As such, heat generated from the transistor can be dissipated through the connecting plug 431, the first UGI structure, and the second UGI structure to the upper thermal vias 833. An UGI heat dissipation network with high heat dissipation efficiency is provided.

In another embodiment, the UGI structures (such as UGI lines in the STI isolation 414) may be isolated from the transistors, but the heat dissipation purpose could still be reached. In other embodiments, the upper thermal vias 833 can extend from the upper surface of the upper interconnection structure 440 to the first UGI structures. The upper thermal via 833 may include (or may be made of) a material having a thermal conductivity higher than Si or SiO₂, such as copper.

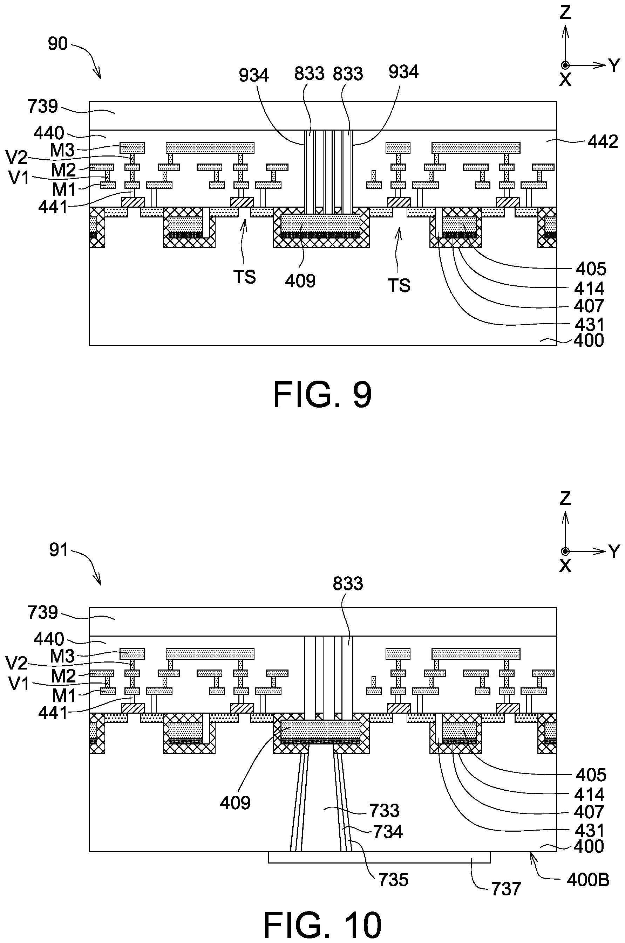

FIG. 9 illustrates a schematic cross-sectional view of a semiconductor circuit structure 90 according to some embodiments of the present disclosure. The difference between the semiconductor circuit structure 90 shown in FIG. 9 and the semiconductor circuit structure 80 shown in FIG. 8 is that, the semiconductor circuit structure 90 includes upper heat dissipation films 934 on sidewalls of the upper thermal vias 833. The upper heat dissipation film 934 may include (or may be made of) a material having a thermal conductivity higher than Si or SiO₂, such as BN orAIN. Configuring upper heat dissipation film 934 on the upper thermal via 833 can improve heat dissipation efficiency.

In some embodiments, the TSV 733 shown in FIG. 7 and the upper thermal via 833 shown in FIG. 8 (or the upper heat dissipation films 934 and the upper thermal vias 833 in FIG. 9) can be combined together, as shown in FIG. 10. In the semiconductor circuit structure 91 shown in FIG. 10, some upper thermal vias 833 extend from the upper surface of the upper interconnection structure 440 to the second UGI structure, and are connected to the top heat dissipation plate 739. The TSV 733 (additional thermal vias) extends from the backside surface 400B of the semiconductor substrate 400 to the second UGI structure (or other UGI structure), and are connected to the heat dissipation plate 737 located on or close to the backside surface 400B of the semiconductor substrate 400. Such sandwich structure (with middle UGI structures in the chip, the top heat dissipation plate connected to the middle UGI structures, and the heat dissipation plate on the backside surface of the semiconductor substrate and connected to the middle UGI structures) can greatly enhance the ability of heat dissipation of the IC chip. In some embodiments, the barrier film 735 and/or the heat dissipation film 734 can be omitted.

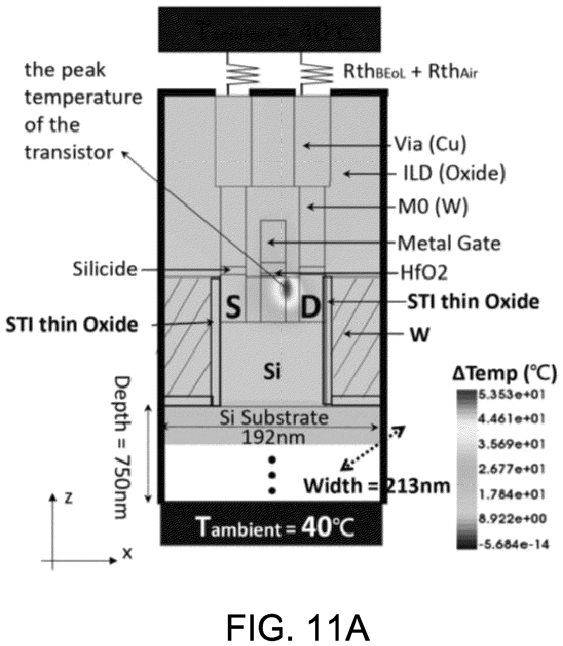

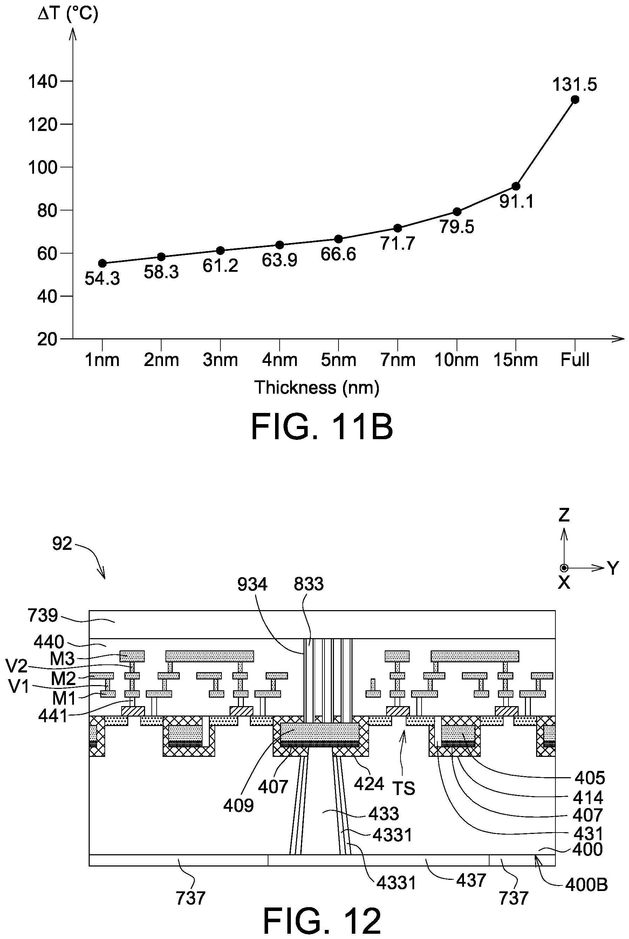

FIG. 11A shows the semiconductor circuit structure including a FinFET transistor and a STI region adjacent to (or surrounding) the FinFET transistor, in which portion of the STI region (marked by slash lines) is replaced by the UGI structure made of Tungsten. FIG. 11A further shows the temperature distribution of FinFET established by Sentaurus of TCAD simulation software. The temperature difference (ΔT) between the peak temperature of the transistor (the hot spot region) and the ambient temperature (40 °C) is calculated when a portion of the STI region is replaced by Tungsten, as shown in FIG. 11B. The term "Full" in FIG. 11B represents that none of the STI region is replaced by Tungsten. The terms "1nm" to "15nm" represent the remaining thickness of the STI region not replaced by Tungsten. It is clear that the smaller the remaining thickness of the STI region, the smaller the temperature difference between the peak temperature of the transistor and the ambient temperature (the better the heat dissipation performance). Thus, the present disclosure can effectively reduce the peak temperature of the transistor.

### 3. Signal Network and Heat Dissipation Network based on UGI in the same chip

The signal delivery and heat dissipation based on the UGI structures according to the present disclosure can be combined together in the same IC chip, as shown in FIG. 12. In the semiconductor circuit structure 92 shown in FIG. 12, some upper thermal vias 833 extend from the upper surface of the upper interconnection structure 440 to the second UGI structure (such as UGI pad) in the big STI region 424, and are connected to the top heat dissipation plate 739. The upper heat dissipation films 934 are on sidewalls of the upper thermal vias 833. The TSV 433 is right under and connected to the second UGI structure (i.e. the UGI pad) within the big STI region 424. The TSV 433 extends from the bottom of the second UGI structure (i.e. the UGI pad) to the backside surface 400B of the semiconductor substrate 400, and is connected to one or more backside conducting pad 437 on the backside surface 400B of the semiconductor substrate 400 (or on the backside of the chip) for power signal or data signal delivery. The bottom heat dissipation plate 737 located on the backside surface 400B of the semiconductor substrate 400 may surround or couples to the backside conducting pad 437.

A heat dissipation film 4331 could be on a sidewall of the TSV 433, and a barrier film 4332 could be on a sidewall of the heat dissipation film 4331. The TSV 433 may include (or may be made of) a conductive material such as copper. The heat dissipation film 4331 may include (or may be made of) a material having a thermal conductivity higher than Si or SiO2, such as BN or AlN, to help dissipate heat. The barrier film 4332 may include a dielectric material such as oxide. In some embodiments, in the same chip/semiconductor substrate, some UGI pads are utilized for signal delivery, and other UGI pads are utilized for heat dissipation.

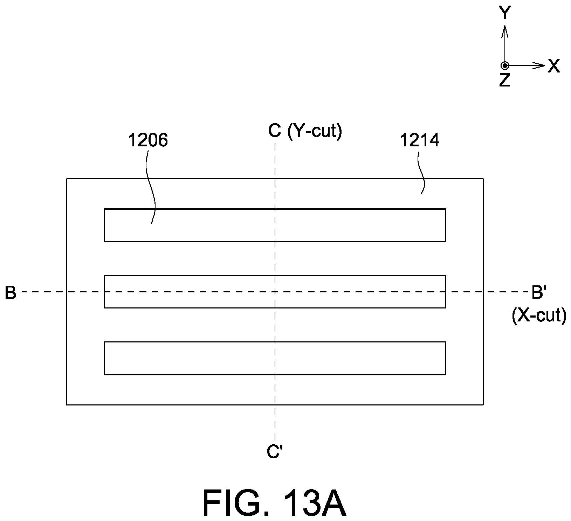

FIGS. 13A to 21 illustrate an exemplary method for manufacturing UGI structures according to some embodiments of the present disclosure.

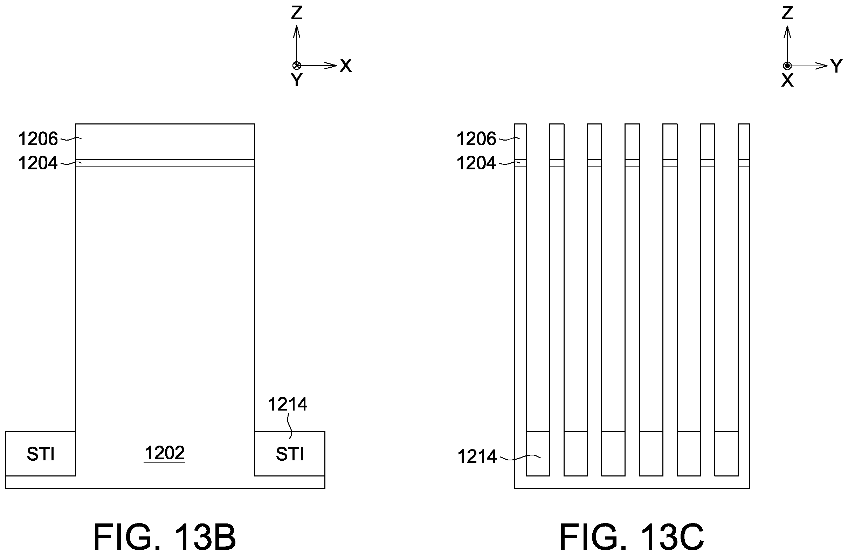

FIG. 13A illustrates a schematic top view of a structure at a stage of the manufacturing method, FIG. 13B illustrates a schematic cross-sectional view of the structure at the stage illustrated along the lines BB' shown in FIG. 13A, and FIG. 13C illustrates a schematic cross-sectional view of the structure at the stage illustrated along the lines CC' shown in FIG. 13A. Referring to FIGS. 13A to 13C, a pad-oxide layer 1204 and a pad-nitride layer 1206 are deposited to define the active areas. A portion of the semiconductor substrate 1202 outside the active areas are removed. The semiconductor substrate 1202 may include or be made of a semiconductor material such as silicon. Then, an oxide layer is deposited and etched back to form portion of shallow trench isolation (STI) regions 1214.

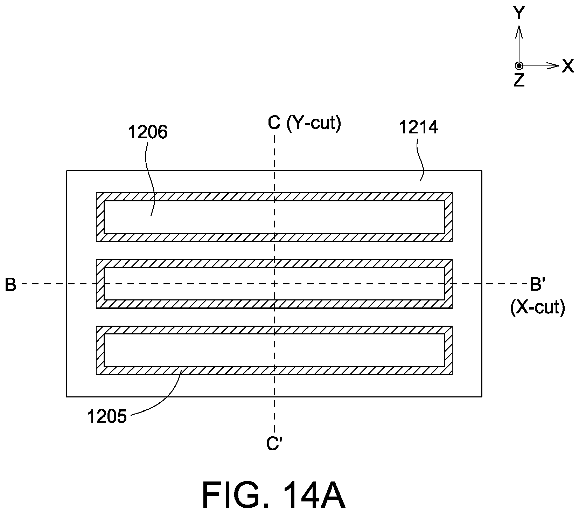

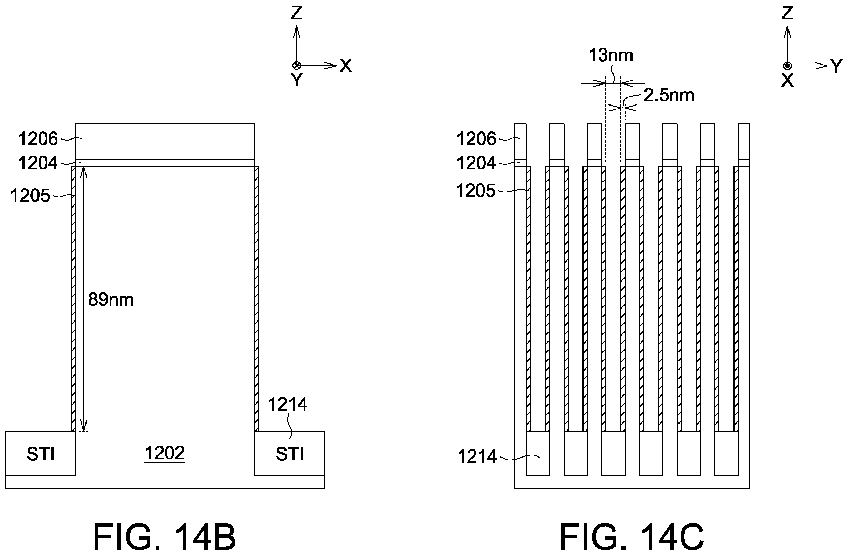

FIG. 14A illustrates a schematic top view of a structure at a stage of the manufacturing method, FIG. 14B illustrates a schematic cross-sectional view of the structure at the stage illustrated along the lines BB' shown in FIG. 14A, and FIG. 14C illustrates a schematic cross-sectional view of the structure at the stage illustrated along the lines CC' shown in FIG. 14A. Referring to FIGS. 14A to 14C, thermal oxide layers 1205 are grown along the revealed sidewalls of the active areas. The thermal oxide layer 1205 may have a length along the Z direction of about 89~200 nm. The thermal oxide layer 1205 may have a thickness along the Y direction of about 2.5 nm. Depending on the pitch of the active areas, the distance between the thermal oxide layers 1205 on different active areas along the Y direction may be about 13 nm. The upper surface of the thermal oxide layer 1205 can be lower than the upper surface of the pad-oxide layer 1204 and the lower surface of the pad-nitride layer 1206 in the Z direction. A portion of the STI region 1214 may be exposed, or the bottom of the STI region 1214 may be covered by the thermal oxide layers 1205 as well..

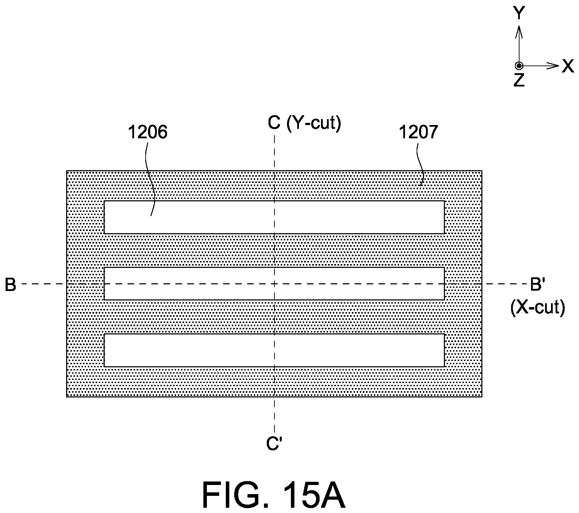

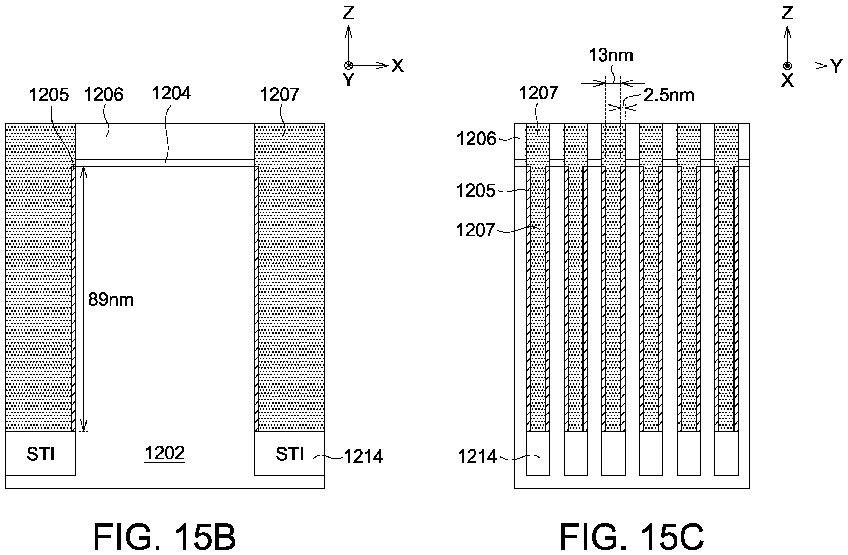

FIG. 15A illustrates a schematic top view of a structure at a stage of the manufacturing method, FIG. 15B illustrates a schematic cross-sectional view of the structure at the stage illustrated along the lines BB' shown in FIG. 15A, and FIG. 15C illustrates a schematic cross-sectional view of the structure at the stage illustrated along the lines CC' shown in FIG. 15A. Referring to FIGS. 15A to 15C, a SOD material 1207 is deposited to fill the spaces between the active areas. A planarization process such as a chemical-mechanical planarization (CMP) process can be performed to remove a portion of the SOD material 1207 above the pad-nitride layer 1206 and make the upper surface of the SOD material 1207 and the upper surface of the pad-nitride layer 1206 coplanar.

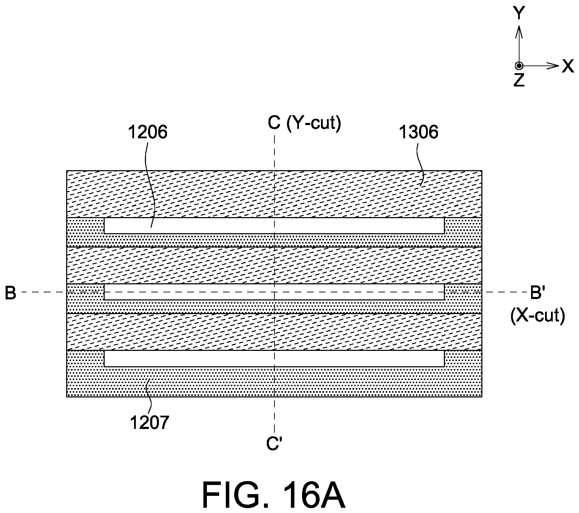

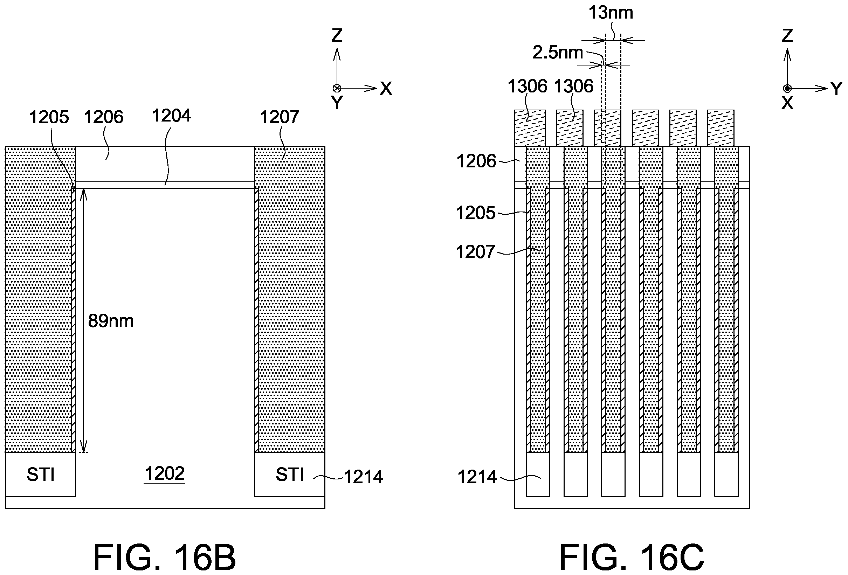

FIG. 16A illustrates a schematic top view of a structure at a stage of the manufacturing method, FIG. 16B illustrates a schematic cross-sectional view of the structure at the stage illustrated along the lines BB' shown in FIG. 16A, and FIG. 16C illustrates a schematic cross-sectional view of the structure at the stage illustrated along the lines CC' shown in FIG. 16A. Referring to FIGS. 16A to 16C, a photo-resistance layer 1306 is formed and patterned to cover a portion of the active area and expose a portion of the SOD material 1207. For example, half or more than half of the active area can be covered by the photo-resistance layer 1306.

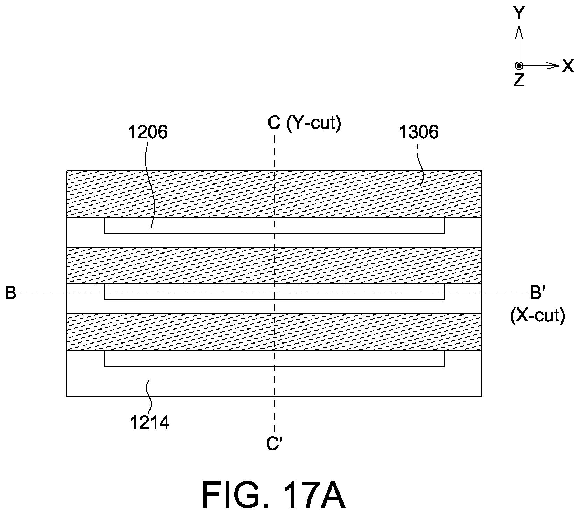

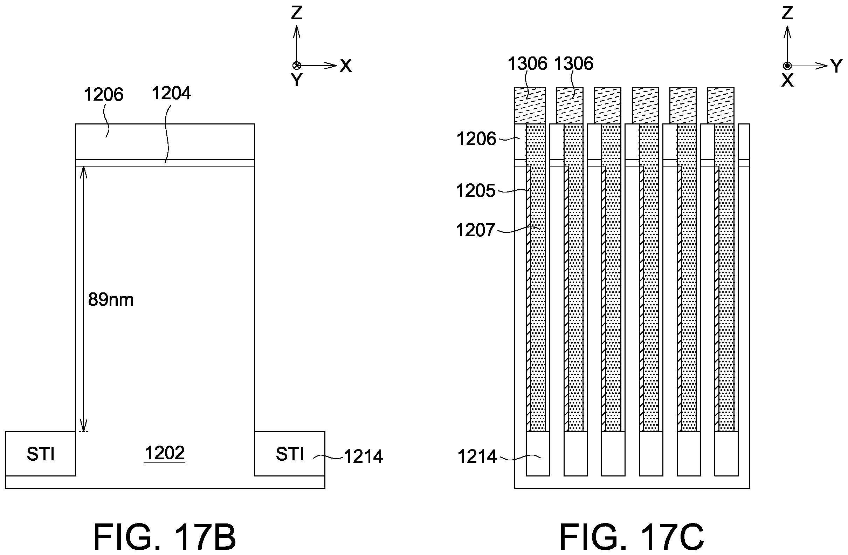

FIG. 17A illustrates a schematic top view of a structure at a stage of the manufacturing method, FIG. 17B illustrates a schematic cross-sectional view of the structure at the stage illustrated along the lines BB' shown in FIG. 17A, and FIG. 17C illustrates a schematic cross-sectional view of the structure at the stage illustrated along the lines CC' shown in FIG. 17A. Referring to FIGS. 17A to 17C, a portion of the SOD material 1207 that is not covered by the photo-resistance layer 1306 and the thermal oxide layer 1205 covered by this portion of the SOD material 1207 are removed to form narrow slots between the retained SOD material 1207 and the active areas. The narrow slot may have a width along the Y direction of 2~5nm, such as 3nm. After the removing of a portion of the SOD material 1207 that is not covered by the photo-resistance layer 1306 and the removing of the thermal oxide layer 1205 thereunder, one sidewall of the active area is exposed in the narrow slot.

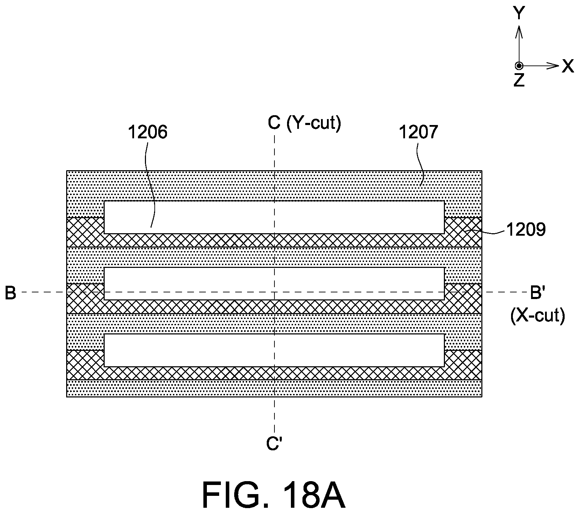

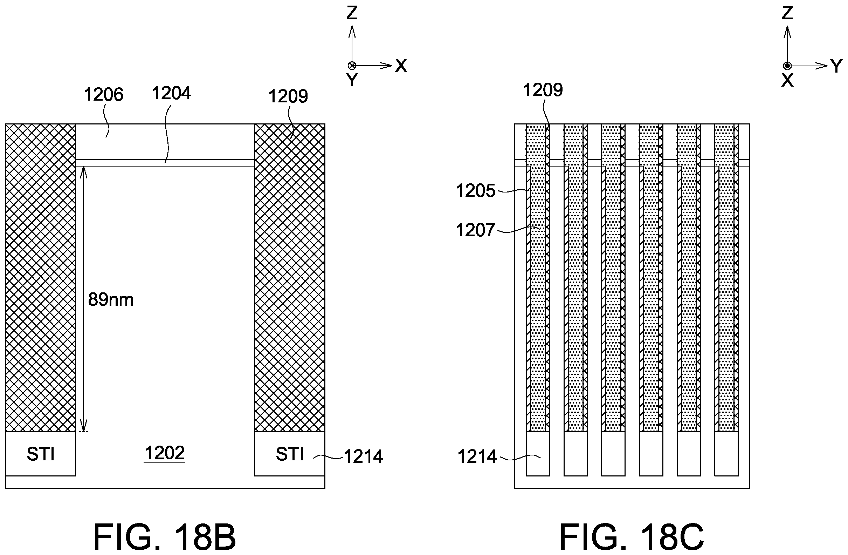

FIG. 18A illustrates a schematic top view of a structure at a stage of the manufacturing method, FIG. 18B illustrates a schematic cross-sectional view of the structure at the stage illustrated along the lines BB' shown in FIG. 18A, and FIG. 18C illustrates a schematic cross-sectional view of the structure at the stage illustrated along the lines CC' shown in FIG. 18A. Referring to FIGS. 18A to 18C, the photo-resistance layer 1306 is removed, and a material (such as SiOCN) 1209 different from the thermal oxide layer 1205 is deposited within the narrow slots. A planarization process such as a CMP process can be performed to remove a portion of the SiOCN material 1209 above the pad-nitride layer 1206 and the SOD material 1207 and make the upper surface of the SiOCN material 1209, the upper surface of the SOD material 1207 and the upper surface of the pad-nitride layer 1206 coplanar. Therefore, asymmetric spacers which include different materials (such as the thermal oxide layer 1205 and the SiOCN material 1209) within the STI region 1214 are formed. In another view, such asymmetric spacers cover two sidewalls of the active regions, respectively.

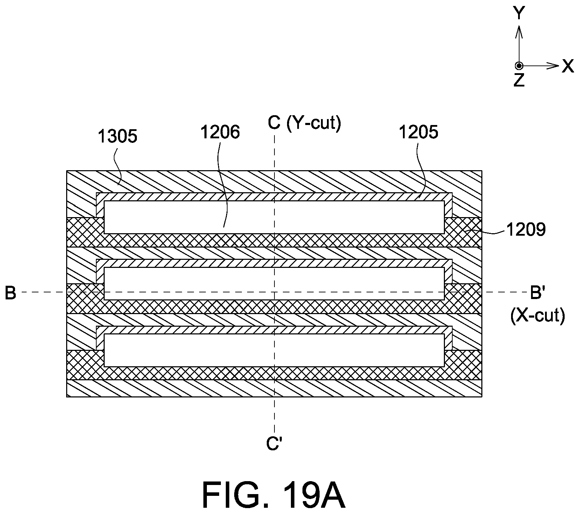

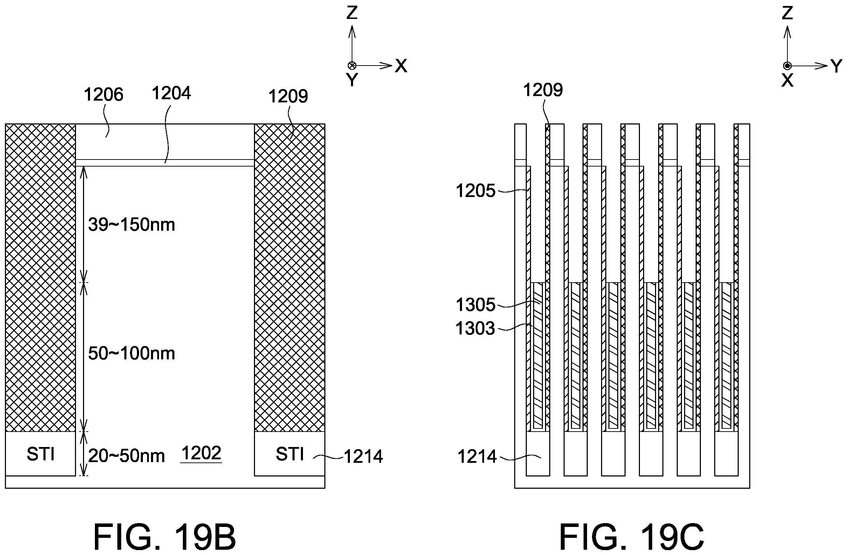

FIG. 19A illustrates a schematic top view of a structure at a stage of the manufacturing method, FIG. 19B illustrates a schematic cross-sectional view of the structure at the stage illustrated along the lines BB' shown in FIG. 19A, and FIG. 19C illustrates a schematic cross-sectional view of the structure at the stage illustrated along the lines CC' shown in FIG. 19A. Referring to FIGS. 19A to 19C, the SOD material 1207 is removed the form spaces between the thermal oxide layer 1205 and the SiOCN material 1209, a TiN layer 1303 and a tungsten layer 1305 are sequentially deposited in the spaces, and then an etch back process is performed to remove a portion of the TiN layers 1303 and a portion of the tungsten layers 1305. After the etch back process, the retained tungsten layers 1305 can be defined as underground interconnection (UGI) structures, and the retained TiN layers 1303 can be defined as barrier layers. The TiN layer 1303 is between the tungsten layer 1305 and the thermal oxide layer 1205. The TiN layer 1303 is between the tungsten layer 1305 and the SiOCN material 1209. The TiN layer 1303 is between the tungsten layer 1305 and the STI region 1214. A distance between the upper surface of the thermal oxide layer 1205 and the upper surface of the tungsten layers 1305 along the Z direction could be 39~150 nm. A distance between the upper surface of the tungsten layers 1305 and the upper surface of the STI region 1214 along the Z direction could be 50~150 nm. A thickness of the STI region 1214 along the Z direction could be 20~50 nm.

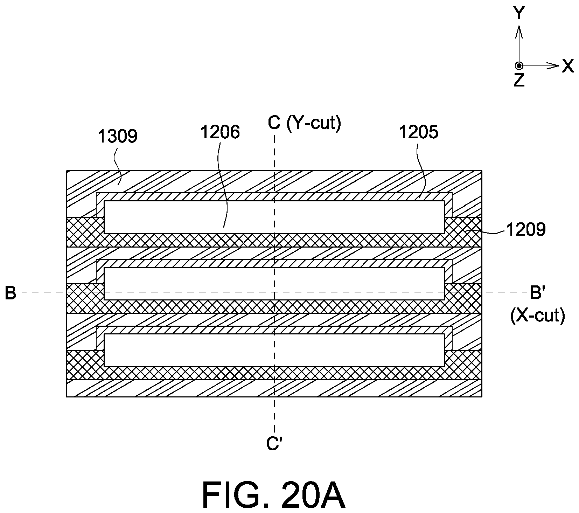

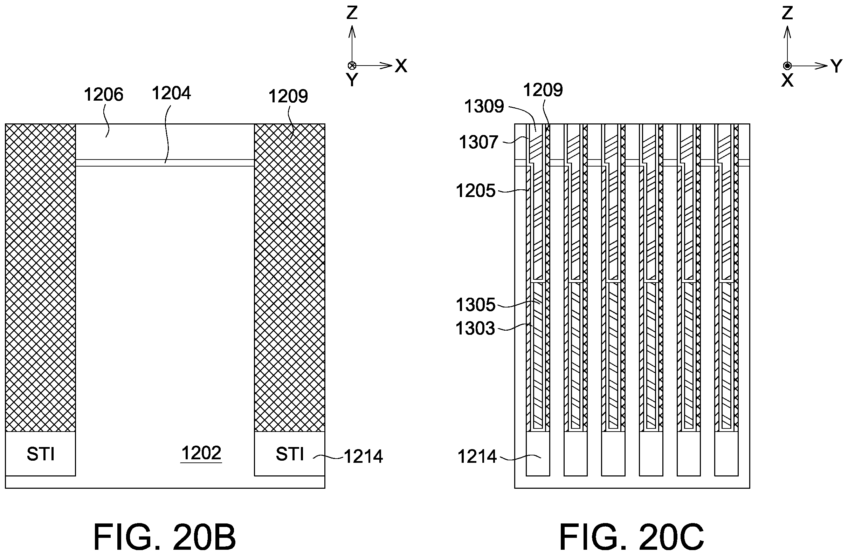

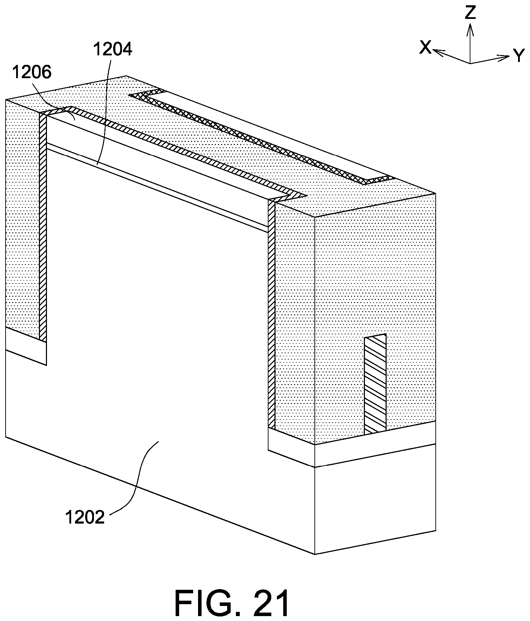

FIG. 20A illustrates a schematic top view of a structure at a stage of the manufacturing method, FIG. 20B illustrates a schematic cross-sectional view of the structure at the stage illustrated along the lines BB' shown in FIG. 20A, and FIG. 20C illustrates a schematic cross-sectional view of the structure at the stage illustrated along the lines CC' shown in FIG. 20A. Referring to FIGS. 20A to 20C, a SiN layer 1307 and a HDP (high density plasma) oxide layer 1309 are sequentially formed above the tungsten layers 1305 and the TiN layer 1303. Thus, the STI region between the active areas is completed. Therefore, underground interconnection structures within STI regions is provided, and a three-dimensional schematic view of the structure is shown in FIG. 21. Manufacturing steps for forming transistors in the active areas can be performed after the stage shown in FIG. 20A to 20C.

In one example, the UGI structure or UGI element within and extending along the STI region can be connected to a source terminal or a drain terminal of the transistor by a connecting plug within the active area. For example, after removing portion of the active area to form a trench therein, the asymmetrical spacers of the SiOCN material 1209 and the thermal oxide layer 1205 are revealed in the trench. Then form thermal oxide to cover the revealed Si portion in the trench, such that only one sidewall of the trench is covered by the SiOCN material 1209. Afterward, remove the SiOCN material 1209 such that the sidewall of the UGI structure is then revealed. Thereafter, a connecting plug (such as Tungsten or heavily doped Si) is filled in the trench to connect the revealed sidewall of the UGI structure.

In the event it is not necessary to connect the UGI structure to a source terminal or a drain terminal of the transistor, the steps to form the asymmetrical spacers of the SiOCN material 1209 and the thermal oxide layer 1205 could be skipped, and just forming the thermal oxide layer 1205 is enough, as shown in FIGs. 14A~14C. Afterward, the UGI structure could be deposited above the STI region 1214, and then other dielectric material (such as the SiN layer 1307 and a HDP oxide layer 1309) is formed above the UGI structure.

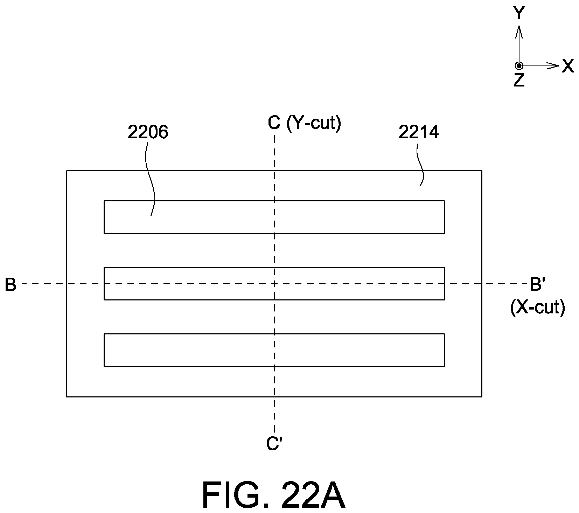

FIGS. 22A to 29C illustrate a method for manufacturing underground interconnection structures within STI regions according to some embodiments of the present disclosure.

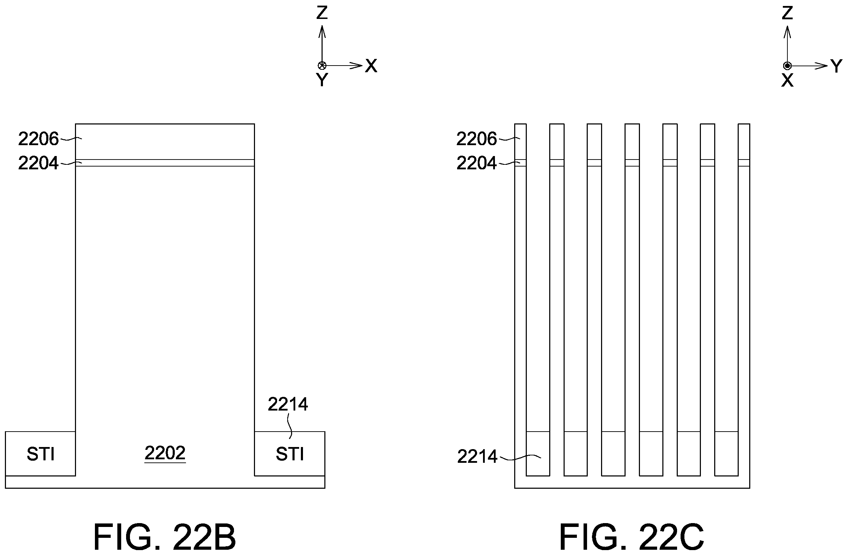

FIG. 22A illustrates a schematic top view of a structure at a stage of the manufacturing method, FIG. 22B illustrates a schematic cross-sectional view of the structure at the stage illustrated along the lines BB' shown in FIG. 22A, and FIG. 22C illustrates a schematic cross-sectional view of the structure at the stage illustrated along the lines CC' shown in FIG. 22A. Referring to FIGS. 22A to 22C, a pad-oxide layer 2204 and a pad-nitride layer 2206 are deposited to define the active areas. A portion of the semiconductor substrate 2202 outside the active areas are removed. The semiconductor substrate 2202 may include or be made of a semiconductor material such as silicon. Then, an oxide layer is deposited and etched back to form shallow trench isolation (STI) regions 2214. A width of the pad-nitride layer 2206 along the Y direction can be 12 nm. A distance between adjacent two active areas along the Y direction can be 18 nm. A distance between the lower surface of the pad-oxide layer 2204 and the upper surface of the STI region 2214 along the Z direction can range from 150 nm to 200 nm.

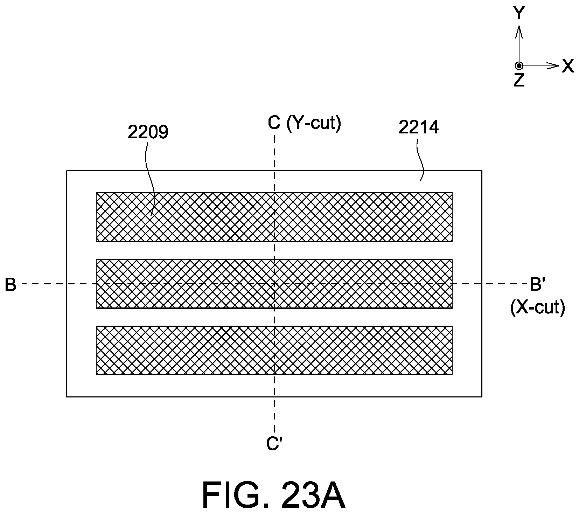

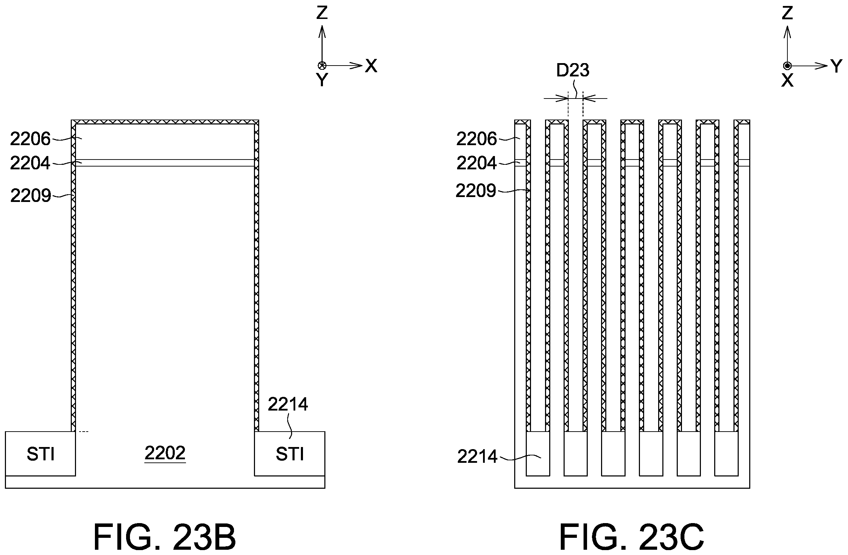

FIG. 23A illustrates a schematic top view of a structure at a stage of the manufacturing method, FIG. 23B illustrates a schematic cross-sectional view of the structure at the stage illustrated along the lines BB' shown in FIG. 23A, and FIG. 23C illustrates a schematic cross-sectional view of the structure at the stage illustrated along the lines CC' shown in FIG. 23A. Referring to FIGS. 23A to 23C, a SiOCN material 2209 is deposited along the sidewall of the semiconductor substrate 2202, the sidewall of the pad-oxide layer 2204, the sidewall of the pad-nitride layer 2206 and the upper surface of the pad-nitride layer 2206. A thickness of the SiOCN material 2209 along the Y direction can be 4 nm. A distance D23 between the sidewalls of the SiOCN material 2209 along the Y direction can be 10 nm. A portion of the STI region 2214 is exposed.

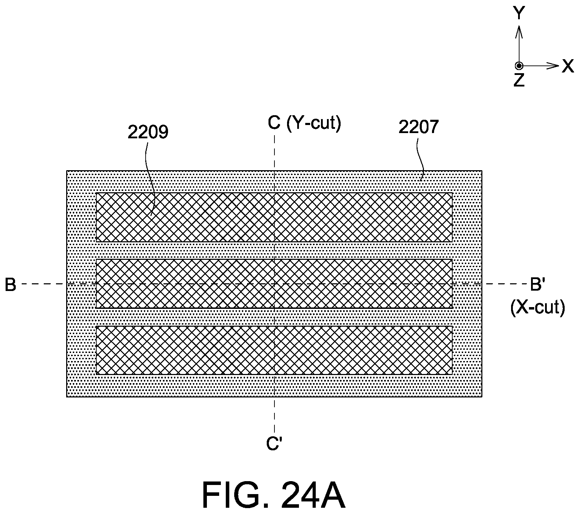

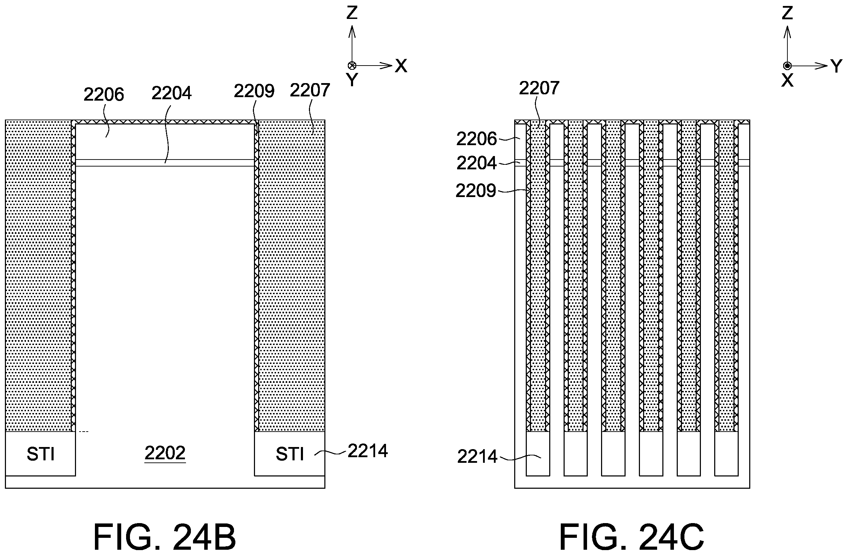

FIG. 24A illustrates a schematic top view of a structure at a stage of the manufacturing method, FIG. 24B illustrates a schematic cross-sectional view of the structure at the stage illustrated along the lines BB' shown in FIG. 24A, and FIG. 24C illustrates a schematic cross-sectional view of the structure at the stage illustrated along the lines CC' shown in FIG. 24A. Referring to FIGS. 24A to 24C, a SOD material 2207 is deposited to fill the spaces between the active areas. A planarization process such as a CMP process can be performed to remove a portion of the SOD material 2207 above the pad-nitride layer 2206 and make the upper surface of the SOD material 2207 and the upper surface of the pad-nitride layer 2206 coplanar.

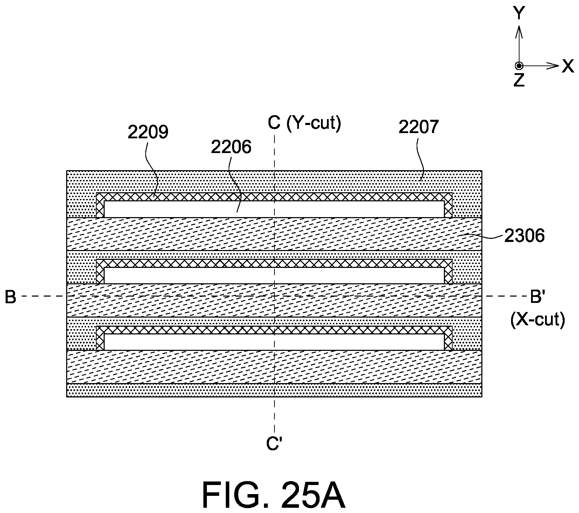

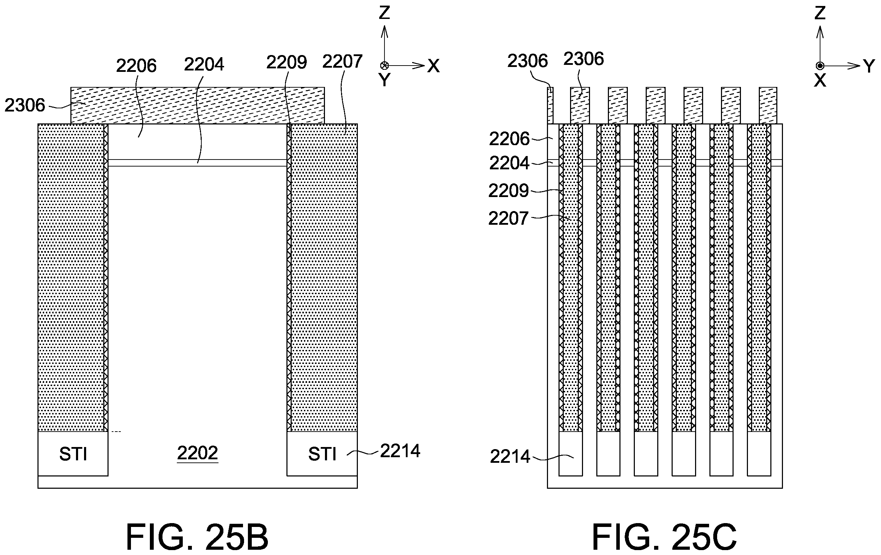

FIG. 25A illustrates a schematic top view of a structure at a stage of the manufacturing method, FIG. 25B illustrates a schematic cross-sectional view of the structure at the stage illustrated along the lines BB' shown in FIG. 25A, and FIG. 25C illustrates a schematic cross-sectional view of the structure at the stage illustrated along the lines CC' shown in FIG. 25A. Referring to FIGS. 25A to 25C, a photo-resistance layer 2306 is formed and patterned to cover a portion of the active area and expose a portion of the SOD material 2207 and a portion of the SiOCN material 2209. For example, half or more than half of the active area can be covered by the photo-resistance layer 2306.

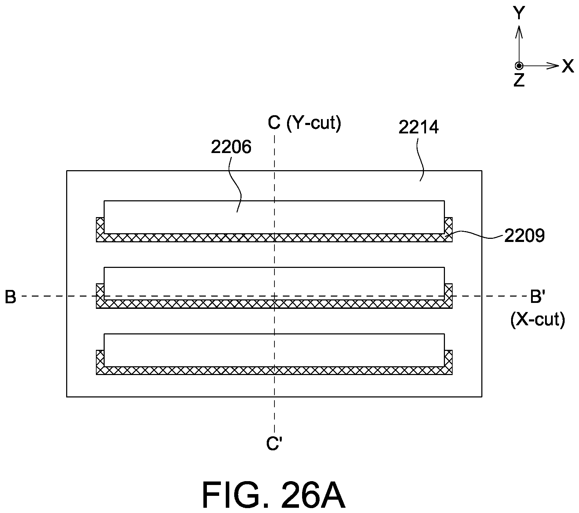

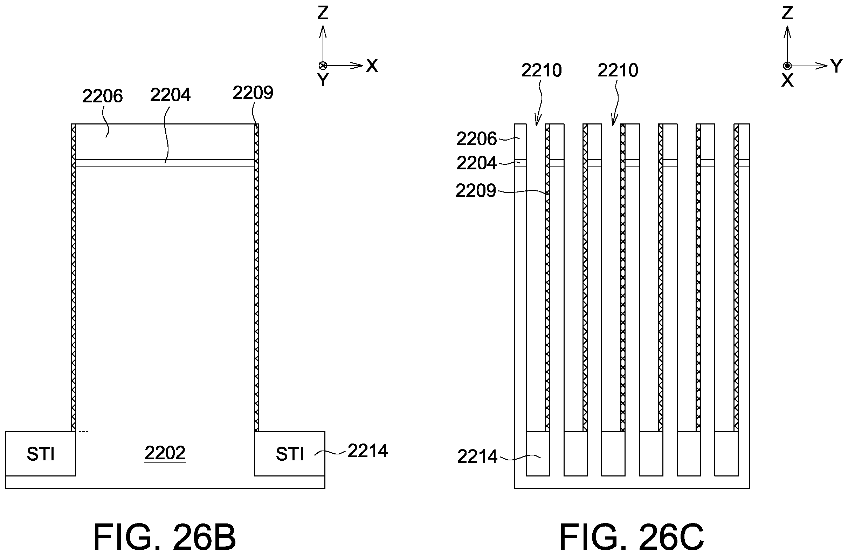

FIG. 26A illustrates a schematic top view of a structure at a stage of the manufacturing method, FIG. 26B illustrates a schematic cross-sectional view of the structure at the stage illustrated along the lines BB' shown in FIG. 26A, and FIG. 26C illustrates a schematic cross-sectional view of the structure at the stage illustrated along the lines CC' shown in FIG. 26A. Referring to FIGS. 26A to 26C, the portion of the SiOCN material 2209 that is not covered by the photo-resistance layer 2306 and the SOD material 2207 are removed, and the photo-resistance layer 2306 is removed. Slots 2210 are formed between the retained SiOCN material 2209 and the active areas. After the removing, one sidewall of each active area is exposed in the slots 2210.

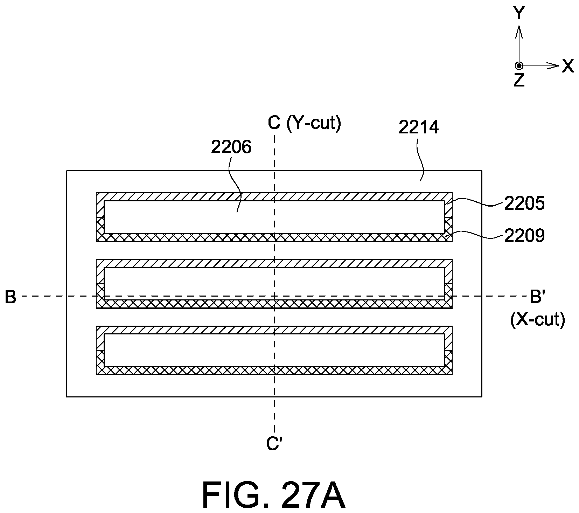

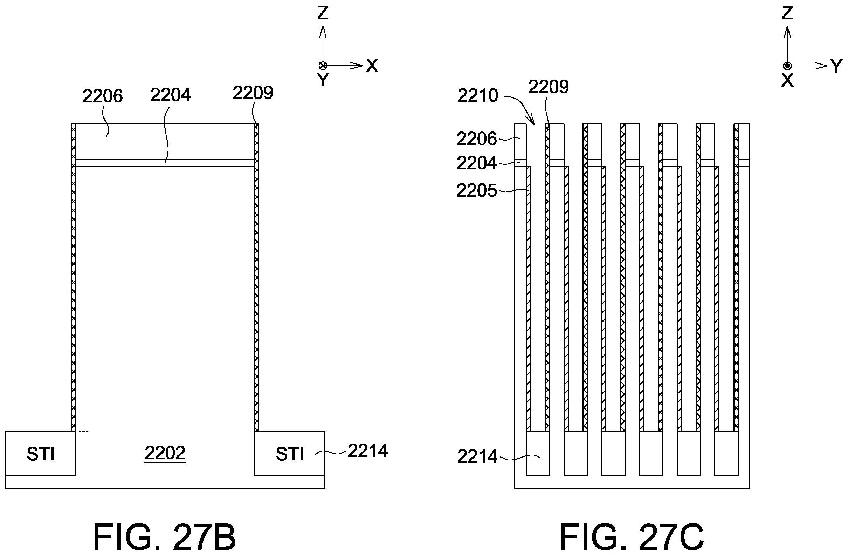

FIG. 27A illustrates a schematic top view of a structure at a stage of the manufacturing method, FIG. 27B illustrates a schematic cross-sectional view of the structure at the stage illustrated along the lines BB' shown in FIG. 27A, and FIG. 27C illustrates a schematic cross-sectional view of the structure at the stage illustrated along the lines CC' shown in FIG. 27A. Referring to FIGS. 27A to 27C, thermal oxide layers 2205 are grown along the exposed sidewalls of the active areas and within the slots 2210. The upper surface of the thermal oxide layer 2205 can be lower than the upper surface of the pad-oxide layer 2204 and the lower surface of the pad-nitride layer 2206 in the Z direction. Therefore, asymmetric spacers which include different materials (such as the thermal oxide layer 2205 and the SiOCN material 2209) within the STI region 2214 are formed. In another view, such asymmetric spacers cover two sidewalls of each active regions.

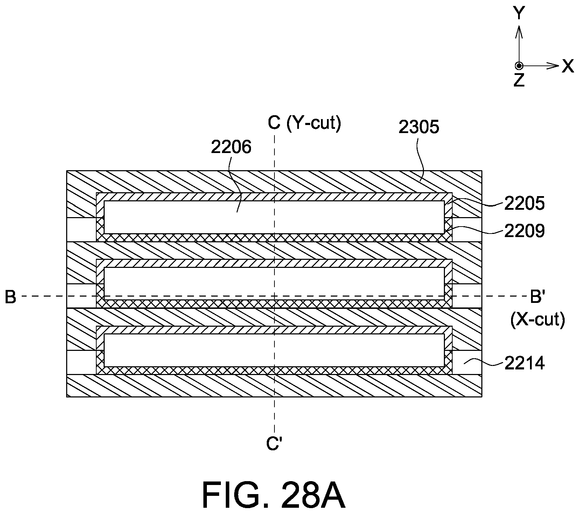

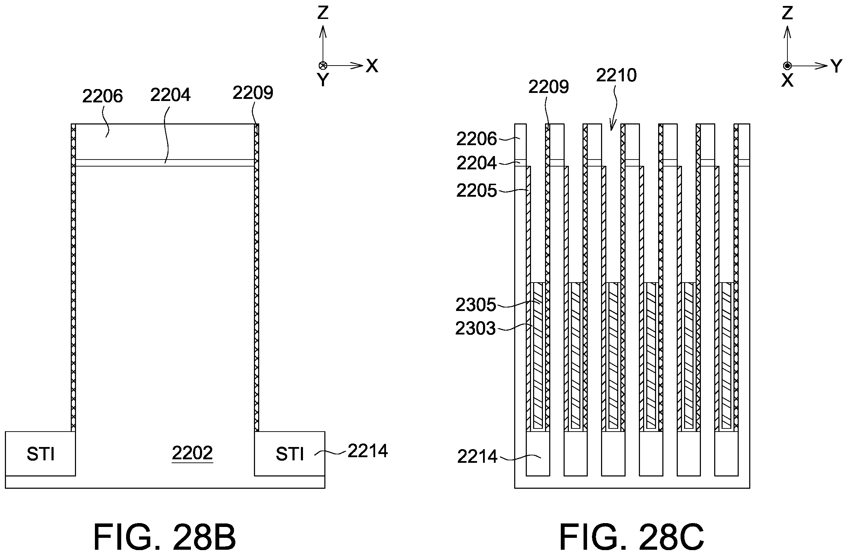

FIG. 28A illustrates a schematic top view of a structure at a stage of the manufacturing method, FIG. 28B illustrates a schematic cross-sectional view of the structure at the stage illustrated along the lines BB' shown in FIG. 28A, and FIG. 28C illustrates a schematic cross-sectional view of the structure at the stage illustrated along the lines CC' shown in FIG. 28A. Referring to FIGS. 28A to 28C, a TiN layer 2303 and a tungsten layer 2305 are sequentially deposited within the slots 2210, and then an etch back process is performed to remove a portion of the TiN layers 2303 and a portion of the tungsten layers 2305. After the etch back process, the retained tungsten layers 2305 can be defined as underground interconnection (UGI) structures, and the retained TiN layers 2303 can be defined as barrier layers.

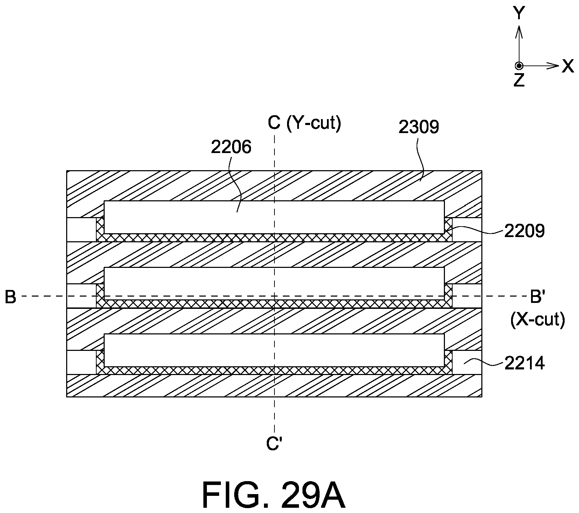

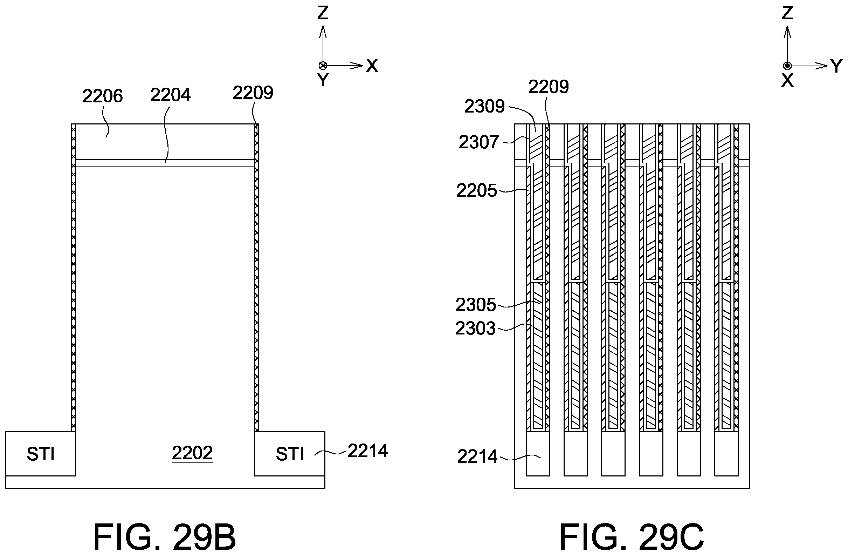

FIG. 29A illustrates a schematic top view of a structure at a stage of the manufacturing method, FIG. 29B illustrates a schematic cross-sectional view of the structure at the stage illustrated along the lines BB' shown in FIG. 29A, and FIG. 29C illustrates a schematic cross-sectional view of the structure at the stage illustrated along the lines CC' shown in FIG. 29A. Referring to FIGS. 29A to 29C, a SiN layer 2307 and a HDP (high density plasma) oxide layer 2309 are sequentially formed above the tungsten layers 2305 and the TiN layer 2303. Therefore, a structure including underground interconnection structures within STI regions is provided. Manufacturing steps for forming transistors in the active areas can be performed after the stage shown in FIG. 29A to 29C.

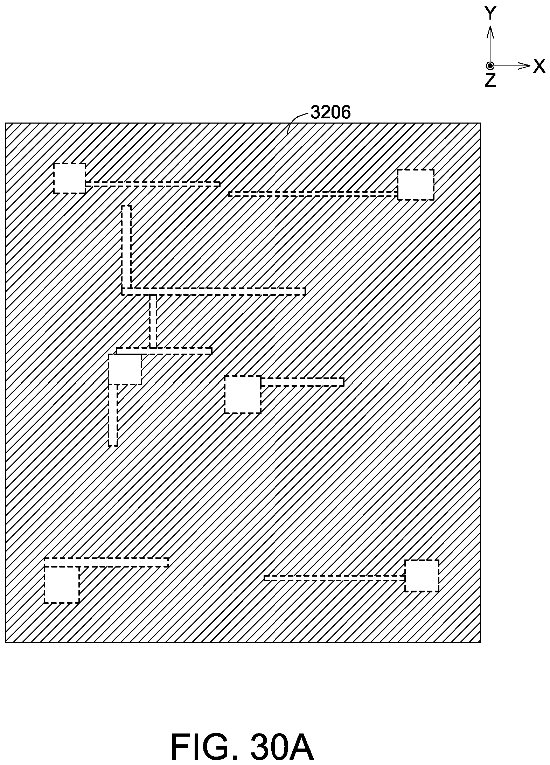

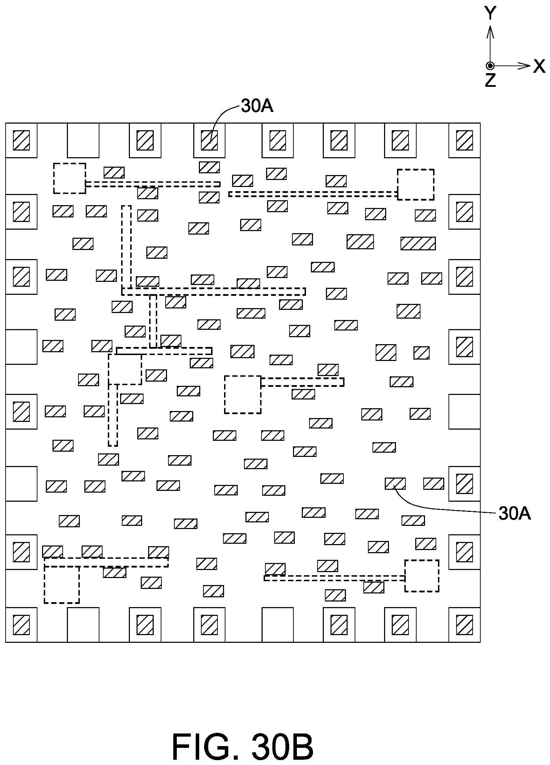

FIGS. 30A to 30B illustrate an exemplary method for manufacturing an UGI mesh according to some embodiments of the present disclosure. FIGS. 30A to 30B illustrate schematic top views of structures at different stages of the manufacturing method. A pad-oxide layer and a pad-nitride layer 3206 are sequentially deposited on the semiconductor substrate. Then, temporary active areas could be firstly defined by a photolithographic process, and the STI regions and the big STI regions (indicated by dotted lines in FIG. 30A) can be defined outside the temporary active areas. The materials of the UGI structures are then formed in the STI regions and the big STI regions, as previously mentioned. Then, true active areas 30A can defined by another photolithographic process, and the removed temporary active areas then be used for rest STI regions, as shown in FIG. 30B.

The present disclosure provides underground interconnection structures (e.g. UGI lines and UGI pads) under the original semiconductor surface and within the STI regions. The UGI structures are isolated from the semiconductor substrate, and depending on the requirement, some UGI structures could be connected to the transistors. The underground interconnection structures can form a UGI mesh (or can be understood as a mid-side signal/power delivery network or a heat dissipation network) within the chip or semiconductor substrate, which provides bigger misalignment tolerance due to the big STI regions with a lot of space for signal path, and shorten the path to connect backside TSVs to UGI mesh to improve IR drop of the signal delivery, and enhance the heat dissipation.

It is noted that the structures and methods as described above are provided for illustration. The disclosure is not limited to the configurations and procedures disclosed above. Other embodiments with different configurations of known elements can be applicable, and the exemplified structures could be adjusted and changed based on the actual needs of the practical applications. It is, of course, noted that the configurations of figures are depicted only for demonstration, not for limitation. Thus, it is known by people skilled in the art that the related elements and layers in a semiconductor structure, the shapes or positional relationship of the elements and the procedure details could be adjusted or changed according to the actual requirements and/or manufacturing steps of the practical applications.

While the disclosure has been described by way of example and in terms of the exemplary embodiment(s), it is to be understood that the disclosure is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A semiconductor circuit structure (40), comprising:
a semiconductor substrate (400) with an original semiconductor surface (400S);
a set of transistors (TS) formed based on the semiconductor substrate, wherein each transistor (TS) comprises a gate structure (T3), a first conductive region (T1), and a second conductive region (T2);
a first shallow trench isolation (STI) region (214, 414) neighboring the set of transistors (TS) and extending along a first direction (X);
a big shallow trench isolation (STI) region (224, 424) remote from the set of transistors (TS);
a first underground interconnection line (205, 405) within the first STI region (214, 414) and positioned under the original semiconductor surface (400S), wherein the first underground interconnection line (205, 405) extends along the first direction; and
a first underground interconnection pad (209, 409) electrically coupled to the first underground interconnection line (205, 405), wherein the first underground interconnection pad (209, 409) is positioned within the big STI region (424) and under the original semiconductor surface (400S), and a width of the first underground interconnection pad (209, 409) is greater than a width of the first underground interconnection line (205, 405).

2. The semiconductor circuit structure of claim 1, wherein the first underground interconnection pad (409) is directly connected to the first underground interconnection line (405).

3. The semiconductor circuit structure of claim 1 or 2, further comprising a through semiconductor via (TSV) (433) extending from a bottom surface of the first underground interconnection pad (409) to a backside surface (400B) of the semiconductor substrate (400), wherein the TSV (433) is electrically connected to the first underground interconnection pad (409) and configured to transmit a power signal or a data signal from the backside surface (400B) of the semiconductor substrate (400) to the first underground interconnection pad (409), and the backside surface (400B) is opposite to the original semiconductor surface (400S).

4. The semiconductor circuit structure of claim 3, wherein the first conductive region (T1) of a first transistor (TS) of the set of transistors is electrically connected to the first underground interconnection line (405) through a connecting plug (431) positioned within an active area (AA) accommodating the first transistor (TS), the power signal or the data signal is transmitted to the first transistor (TS) through the first underground interconnection pad (409), the first underground interconnection line (405), and the corresponding connecting plug (431), preferably wherein the connecting plug (431) contacts a sidewall of the first underground interconnection line (405).

5. The semiconductor circuit structure of claim 3 or 4, wherein both the first underground interconnection pad (409) and the first underground interconnection line (405) comprise W and TiN.

6. The semiconductor circuit structure of anyone of the claims 3 to 5, wherein the TSV (433) comprises a Cu pillar.

7. The semiconductor circuit structure of anyone of the claims 1 to 6, further comprising a conducting pad (437) close to the backside surface (400B) of the semiconductor substrate (400) and connected to the TSV (433).

8. The semiconductor circuit structure of anyone of the claims 1 to 7, further comprising:
a second shallow trench isolation (STI) region (314) remote from the set of transistors; and
a second underground interconnection line (305) within the second STI region (314) and positioned under the original semiconductor surface (400S), wherein the second underground interconnection line (305) extends along a second direction (Y) different from the first direction (X);
wherein the second underground interconnection line (305) is connected to the first underground interconnection line (205) or the second underground interconnection line (305) is connected to the first underground interconnection pad (314).
line (305) is connected to the first underground interconnection pad (314).

9. The semiconductor circuit structure of anyone of the claims 1 to 8, further comprising:
a plurality of metal layers (M1, M2, M3) positioned above the original semiconductor surface (400S) and vertically separately from each other; and
a plurality of connecting vias (V1, V2) above the original semiconductor surface (400S) and electrically connected to the plurality of metal layers (M1, M2, M3),
wherein the first conductive region (T1) of a first transistor (TS) of the set of transistors is electrically connected to the first underground interconnection pad (409) through the plurality of metal layers (M1, M2, M3) and the plurality of connecting vias (V1, V2).

10. The semiconductor circuit structure of anyone of the claims 1 to 8, further comprising:
a plurality of metal layers (M1, M2, M3) positioned above the original semiconductor surface (400S) and vertically separately from each other;
a plurality of connecting vias (V1, V2) above the original semiconductor surface (400S) and electrically connected to the plurality of metal layers (M1, M2, M3); and
a second underground interconnection pad (209, 409) positioned under the original semiconductor surface (400S), wherein a width of the second underground interconnection pad (209, 409) is greater than the width of the first underground interconnection line (205, 405),
wherein the first underground interconnection pad (209, 409) is electrically connected to the second underground interconnection pad (209, 409) through the plurality of metal layers (M1, M2, M3) and the plurality of connecting vias (V1, V2).

11. A semiconductor circuit structure comprising:
a semiconductor substrate (400) with an original semiconductor surface (400S);
a set of transistors (TS) formed based on the semiconductor substrate (400);
a first shallow trench isolation (STI) region (214) neighboring the set of transistors and extending along a first direction (X);
a second shallow trench isolation (STI) region (314) remote from the set of transistors;
a big shallow trench isolation (STI) region (224) remote from the set of transistors;
a first underground interconnection line (205) within the first STI region (214) and positioned under the original semiconductor surface (400S), wherein the first underground interconnection line (205) extends along the first direction (X);
a second underground interconnection line (305) within the second STI region (314) and positioned under the original semiconductor surface (400S), wherein the second underground interconnection line (305) extends along a second direction (Y) different from the first direction; and
a first underground interconnection pad (209) positioned within the big STI region (224) and under the original semiconductor surface (400S);
wherein the second underground interconnection line (305) is connected to the first underground interconnection line (205) or the first underground interconnection pad (209).

12. The semiconductor circuit structure of claim 11, wherein a width of the first underground interconnection pad (209) is greater than a width of the first underground interconnection line (205) and/or wherein the first underground interconnection pad (209) is connected to the first underground interconnection line (205).

13. The semiconductor circuit structure of claim 11 or 12, further comprising:
a third shallow trench isolation (STI) region (214) remote from the set of transistors; and
a third underground interconnection line (205) within the third STI region (214) and positioned under the original semiconductor surface (400S), wherein the third underground interconnection line (205) extends along the first direction (X),
wherein the second underground interconnection line (305) is between and connected to the first underground interconnection line (205) and the third underground interconnection line (205).

14. A semiconductor circuit structure, comprising:
a semiconductor substrate (400) with an original semiconductor surface (400S);
a set of transistors (TS) formed based on the semiconductor substrate (400S), wherein each transistor (TS) comprises a gate structure (T3), a first conductive region (T1), and a second conductive region (T2);
a first shallow trench isolation (STI) region (214) neighboring the set of transistors and extending along a first direction (X);
a big shallow trench isolation (STI) region (224, 424) remote from the set of transistors;
a first underground interconnection line (205) within the first STI region (214) and positioned under the original semiconductor surface (400S), wherein the first underground interconnection line (205) extends along the first direction (X);
a first underground interconnection pad (209, 409) electrically coupled to the first underground interconnection line (205), wherein the first underground interconnection pad (209, 409) is positioned within the big STI region (224, 424) and under the original semiconductor surface (400S); and
a through semiconductor via (TSV) (433) within the big STI region (424) and connected to the first underground interconnection pad (409), wherein the big STI region (224) extends from an edge of the first STI region (214), and the first underground interconnection pad (209) is directly connected to the first underground interconnection line (205).

15. The semiconductor circuit structure of claim 14, wherein the TSV (433) extends from a bottom surface of the first underground interconnection pad (409) to a backside surface (400B) of the semiconductor substrate (400), and is configured to transmit a power signal or a data signal from the backside surface of (400B) the semiconductor substrate (400) to the first underground interconnection pad (409), and the backside surface (400B) is opposite to the original semiconductor surface (400S), preferably
wherein the first conductive region (T1) of a first transistor (TS) of the set of transistors is electrically connected to the first underground interconnection line (405) through a connecting plug (431) positioned within an active area accommodating the first transistor, the power signal or the data signal is transmitted to the first transistor (TS) through the first underground interconnection pad (409), the first underground interconnection line (405), and the corresponding connecting plug (431), wherein the connecting plug (431) contacts a sidewall of the first underground interconnection line (405).

16. The semiconductor circuit structure of claim 14 or 15, further comprising a conducting pad (437) close to a backside surface (400B) of the semiconductor substrate (400) and connected to the TSV (433).
